(19) Europäisches Patentamt
European Patent Office
Office européen des brevets

(11) EP 4 007 172 A1

(12) # EUROPÄISCHE PATENTANMELDUNG

(43) Veröffentlichungstag:
**01.06.2022 Patentblatt 2022/22**

(21) Anmeldenummer: **21210498.8**

(22) Anmeldetag: **25.11.2021**

(51) Internationale Patentklassifikation (IPC):
***H03M 1/06*** *(2006.01)* ***H03M 3/00*** *(2006.01)*
***H03M 1/66*** *(2006.01)*

(52) Gemeinsame Patentklassifikation (CPC):
**H03M 3/34; H03M 1/066; H03M 1/66; H03M 3/39; H03M 3/458; H03M 3/464; H03M 3/466; H03M 3/474**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **27.11.2020 DE 102020131464**
**29.10.2021 DE 102021128262**

(71) Anmelder: **Infineon Technologies AG**
**85579 Neubiberg (DE)**

(72) Erfinder:
- **MOTZ, Mario**
**9241 Wernberg (AT)**
- **BRUGGER, Florian**
**9500 Villach (AT)**
- **GARCIA ROJAS, Carlos Humberto**
**9500 Villach (AT)**
- **WERTH, Tobias**
**9500 Villach (AT)**

(74) Vertreter: **Sticht, Andreas**
**Kraus & Weisert**
**Patentanwälte PartGmbB**
**Thomas-Wimmer-Ring 15**
**80539 München (DE)**

(54) **ANALOG-DIGITAL-WANDLER-VORRICHTUNG, SENSORSYSTEM UND VERFAHREN ZUR ANALOG-DIGITAL-WANDLUNG**

(57) Es werden Vorrichtungen und Verfahren zur Analog-DigitalWandlung und entsprechende Systeme mit einem Sensor und einer derartigen Vorrichtung bereitgestellt. Dabei erfolgt eine Demodulation ohne variable Vorverstärkung gefolgt von einer zumindest in Zeitabschnitten zeitkontinuierlichen Analog-Digital-Wandlung, welche zudem Choppertechniken benutzt.

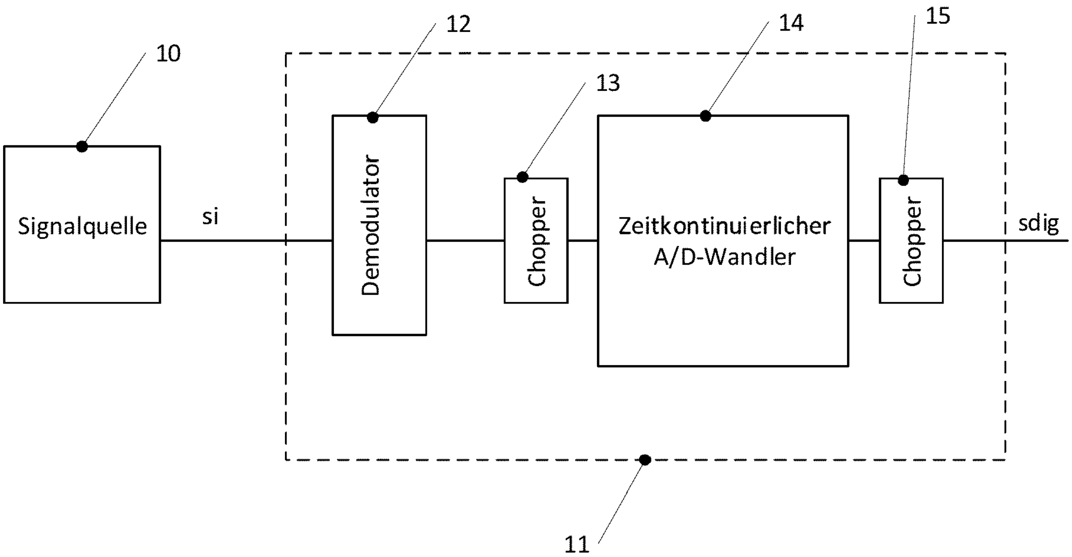


Fig. 1

EP 4 007 172 A1

**Beschreibung**

TECHNISCHES GEBIET

Die vorliegende Anmeldung betrifft Vorrichtungen zur Analog-Digital-Wandlung, Sensorsysteme, die derartige Vorrichtungen zur Wandlung eines von einem Sensor ausgegebenen Analogsignals aufweisen, sowie entsprechende Verfahren.

HINTERGRUND

In vielen Anwendungen wird ein analoges Signal in ein digitales Signal gewandelt, und dann digital weiter verarbeitet. Ein Beispiel sind Sensoranwendungen, bei denen mittels eines Sensors eine physikalische Größe, beispielsweise Geschwindigkeit, Position und dergleichen, erfasst wird, ein entsprechendes analoges Signal von dem Sensor ausgegeben wird und dann in ein digitales Signal gewandelt wird, um weiterverarbeitet zu werden.

In manchen Fällen kann das zu wandelnde Analogsignal einen relativ hohen Dynamikbereich, beispielsweise hinsichtlich einer Spannung des Signals, aufweisen. Ein Beispiel für Sensoren, die einen derartigen hohen Dynamikbereich in ihrem Ausgangssignal aufweisen können, sind induktive Bewegungssensoren. Bei solchen Sensoren wird durch zuführen eines Anregungssignals an eine Anregungsspule ein hochfrequentes Magnetfeld erzeugt. Mittels mehrerer Detektionsspulen wird das Magnetfeld gemessen. Die magnetische Kopplung zwischen Anregungsspule und Detektionsspulen hängt dabei beispielsweise von einer Position eines Rotors, welcher mit einer Induktivität versehen ist, ab. Das Anregungssignal kann dabei eine Frequenz im Bereich von 3,5 MHz aufweisen. Eine von den Empfangsspulen ausgegebene Spannung kann beispielsweise in einem Bereich zwischen 4 und 120 mV liegen, was einem Faktor 30 zwischen der kleinsten und größten Spannung entspricht. Zusammen mit der hohen Frequenz (beispielsweise 3,5 MHz) stellt dies eine Herausforderung für die nachfolgende Demodulation (Konvertierung des Sensorsignals auf eine niedrigere Frequenz) und Analog-Digital-Wandlung dar.

Bei herkömmlichen Herangehensweisen werden ein oder mehrere Verstärker mit variabler Verstärkung (AGC, adjustable gain control) verwendet. Je nach Pegel des Eingangssignals wird die variable Verstärkung eingestellt, um so ein von einem Analog-Digital-Wandler letztendlich zu wandelndes Signal mit einem reduzierten Dynamikbereich bereitzustellen. Derartige Verstärker werden häufig mit Tiefpassfiltern kombiniert, um Signalfaltungseffekte (aliasing) zu unterdrücken und unerwünschte hochfrequente Komponenten herauszufiltern. Derartige Tiefpassfilter benötigen eine entsprechende Chipfläche. Auch Verstärker mit variabler Verstärkung benötigen entsprechenden Platz auf dem Chip und erhöhen den Stromverbrauch.

Andere herkömmliche Herangehensweisen benötigen Kanalfilter, um Frequenzen außerhalb eines Nutzfrequenzbereichs (beispielsweise die erwähnten 3,5 MHz) herauszufiltern, und/oder Puffer vor einer Analog-Digital-Wandler-Schaltung, welche zu Offsetfehlern und zusätzlichem Stromverbrauch führen können.

KURZFASSUNG

Es werden eine Analog-Digital-Wandler-Vorrichtung nach Anspruch 1, ein System nach Anspruch 12 sowie ein Verfahren nach Anspruch 15 bereitgestellt. Die Unteransprüche definieren weitere Ausführungsformen.

Gemäß einem Ausführungsbeispiel wird eine Vorrichtung zur Analog-Digital-Wandlung bereitgestellt, umfassend:

einen Demodulator zum Demodulieren eines Eingangssignals mit einem Demodulationssignal, welches eine Demodulationsfrequenz aufweist, ohne variable Vorverstärkung, einen dem Demodulator nachgeschalteten Choppermodulator zum Choppen auf Basis eines Choppersignals,
einen dem Choppermodulator nachgeschalteten zumindest in Zeitabschnitten zeitkontinuierlichen arbeitenden Analog-Digital-Wandler, und
einen Chopperdemodulator zum Choppen auf Basis des Choppersignals.

Gemäß einem weiteren Ausführungsbeispiel wird eine Vorrichtung zur Analog-Digital-Wandlung bereitgestellt, umfassend:
einen zumindest in Zeitabschnitten zeitkontinuierlichen arbeitenden Analog-Digital-Wandler, welcher aufweist:

mindestens eine Integratorkapazität, die mit dem übrigen Analog-Digital-Wandler in Abhängigkeit von einem Choppersignals verbunden ist, wobei das Choppersignal eine Frequenz aufweist, die gleich einer Demodulationsfrequenz zum Demodulieren eines Eingangssignals der Vorrichtung ist, und
einen Chopperdemodulator zum Choppen auf Basis des Choppersignals.

Gemäß einem weiteren Ausführungsbeispiel wird ein System bereitgestellt, umfassend:

einen Sensor, und
eine Vorrichtung zur Analog-Digital-Wandlung wie oben beschrieben zum Verarbeiten eines Signals von dem Sensor.

Gemäß noch einem weiteren Ausführungsbeispiel wird ein Verfahren zur Analog-Digital-Wandlung bereitgestellt, umfassend:

direktes Demodulieren eines Eingangssignals ohne variable Vorverstärkung, und
zumindest in Zeitabschnitten zeitkontinuierliches Analog-Digital-Wandeln des demodulierten Eingangssignals mit Choppermodulation und Chopperdemodulation.

Gemäß einem weiteren Ausführungsbeispiel wird ein Verfahren zur Analog-Digital-Wandlung bereitgestellt, umfassend zumindest in Zeitabschnitten zeitkontinuierliches Analog-Digital-Wandeln eines Eingangssignals, wobei das zumindest in Zeitabschnitten zeitkontinuierliches Analog-Digital-Wandeln ein Betreiben von Integratorkapazitäten basierend auf einem Choppersignal umfasst, wobei das Choppersignal eine Chopperfrequenz aufweist, die gleich einer Demodulationsfrequenz zum Demodulieren eines zu wandelnden Eingangssignals ist.

Die obige Kurzfassung stellt lediglich einen kurzen Überblick über manche Ausführungsformen dar und ist nicht als einschränkend auszulegen. Insbesondere können andere Ausführungsformen andere Merkmale als die oben genannten aufweisen.

KURZE BESCHREIBUNG DER ZEICHNUNGEN

Fig. 1 ist ein Blockdiagramm eines Systems gemäß einem Ausführungsbeispiel.

Fig. 2 ist ein Diagramm eines Systems gemäß einem Ausführungsbeispiel.

Fig. 3 ist ein Schaltungsdiagramm eines Systems gemäß einem Ausführungsbeispiel.

Fig. 4 zeigt Beispielsignale zur Veranschaulichung der Funktionsweise von manchen Ausführungsbeispielen.

Fig. 5 zeigt Beispielsignale zur Veranschaulichung der Funktionsweise von manchen Ausführungsbeispielen.

Fig. 6 zeigt ein schematisches Schaltungsdiagramm eines zeitkontinuierlichen Analog-Digital-Wandlers zur Erläuterung mancher Ausführungsbeispiele.

Fig. 7 zeigt ein vereinfachtes Schaltungsdiagramm eines Analog-Digital-Wandlers mit geschalteten Eingangskondensator als Vergleichsbeispiel zur Fig. 6.

Fig. 8 zeigt ein Schaltungsdiagramm eines Systems gemäß einem Ausführungsbeispiel.

Fig. 9 zeigt ein Schaltungsdiagramm eines Systems gemäß einem Ausführungsbeispiel.

Fig. 10 zeigt ein Schaltungsdiagramm eines Systems gemäß einem Ausführungsbeispiel.

Fig. 11 zeigt ein Schaltungsdiagramm eines Systems gemäß einem Ausführungsbeispiel.

Fig. 12 zeigt ein Diagramm mit Signalen zur Veranschaulichung mancher Ausführungsbeispiele.

Fig. 13 ist ein Diagramm zur Veranschaulichung der Vorhersage eines nächsten Startwertes.

Fig. 14 ist ein Flussdiagramm zur Veranschaulichung von Verfahren gemäß mancher Ausführungsbeispiele.

Fig. 15A ist ein Schaltungsdiagramm eines Systems gemäß einem Ausführungsbeispiel.

Fig. 15B veranschaulicht einen Spannungs/Stromwandler der Fig. 15A.

Fig. 15C ist ein Diagramm zur Veranschaulichung des Systems der Fig. 15A.

Fig. 16A ist ein Schaltungsdiagramm eines Systems gemäß einem Ausführungsbeispiel.

Fig. 16B veranschaulicht einen Operationsverstärker der Fig. 16A.

Fig. 17A bis 17C zeigen verschiedene Ausführungsbeispiele zur Synchronisierung von Signalen.

Fig. 18 bis 22 sind Schaltungsdiagramme von Systemen gemäß verschiedener Ausführungsbeispiele.

DETAILLIERTE BESCHREIBUNG

Im Folgenden werden verschiedene Ausführungsbeispiele detailliert erläutert. Diese Ausführungsbeispiele sind nicht als einschränkend auszulegen, sondern dienen lediglich der Veranschaulichung. Beispielsweise werden manche Ausführungsbeispiele mit einer Vielzahl von Merkmalen (Komponenten, Vorrichtungen, Verfahrensschritten, Vorgängen, und dergleichen) beschrieben. Bei anderen Ausführungsbeispielen können manche dieser Merkmale weggelassen sein oder durch alternative Merkmale ersetzt werden. Merkmale verschiedener Ausführungsbeispiele können kombiniert werden. So können Variationen und Abwandlungen oder spezielle Teile von Vorrichtungen, die für ein Ausführungsbeispiel beschrieben werden, auch auf andere Ausführungsbeispiele angewendet werden und werden daher nicht wiederholt erläutert.

Verbindungen und Kopplungen beziehen sich auf elektrische Verbindungen und Kopplungen, sofern nichts anderes angegeben ist. Derartige Verbindungen oder Kopplungen können modifiziert werden, beispielsweise durch Hinzufügen von Komponenten oder Entfernen von Komponenten, solange die grundsätzliche Funktion der Verbindung oder Kopplung, beispielsweise die Bereitstellung einer Spannung, die Übermittlung eines elektrischen Signals oder die Übermittlung von einer Information nicht wesentlich beeinflusst wird.

Neben den explizit dargestellten Merkmalen können weitere Merkmale, beispielsweise herkömmliche in Sensorsystemen und entsprechenden Schaltungen verwendete Merkmale, bereitgestellt werden.

Die Fig. 1 zeigt ein Blockdiagramm eines Systems, welches eine Analog-Digital-Wandler-Vorrichtung 11 gemäß einem Ausführungsbeispiel aufweist.

Das System der Fig. 1 weist eine Signalquelle 10 auf, welche ein analoges Signal si ausgibt. Das analoge Signal si kann eine relativ hohe Frequenz, beispielsweise größer 1 MHz, größer 3 MHz, oder beispielsweise etwa 3,5 MHz, aufweisen, ist jedoch nicht hierauf beschränkt. Bei manchen Ausführungsbeispielen kann die Signalquelle 10 ein Sensor sein. Insbesondere kann die Signalquelle 10 ein induktiver Sensor sein, wie er später unter Bezugnahme auf die Fig. 2 erläutert wird.

Bei manchen Ausführungsbeispielen kann das Signal si einen großen Dynamikbereich aufweisen, beispielsweise mindestens einen Faktor 10 oder mindestens einen Faktor 20 zwischen kleinster Amplitude (zum Beispiel kleinster Spannung) und größter Amplitude (beispielsweise größter Spannung).

Das Signal si wird in der Vorrichtung 11 direkt einem Demodulator 12 zugeführt. Direkt bedeutet in diesem Fall, dass keine variable Vorverstärkung vorgenommen wird, um den Dynamikbereich des Signals si anzupassen oder zu verringern. Es kann jedoch beispielsweise innerhalb der Signalquelle 10 eine feste Verstärkung oder andere Signalverarbeitung vorgenommen werden. Der Demodulator mischt das Signal si mit einer Demodulationsfrequenz fdemod, um ein Signal in einem niedrigeren Frequenzband zu erhalten. Derartige Demodulationstechniken sind aus der Demodulation von Kommunikationssignalen bekannt, bei denen beispielsweise ein Hochfrequenzsignal durch einen Demodulator in ein Basisbandsignal gewandelt wird. Die Frequenz fdemod kann dabei einer mittleren Frequenz des Signals si entsprechen. Der Demodulator 12 kann ein passiver Demodulator sein.

Dem Demodulator 12 ist ein zeitkontinuierlicher Analog-Digital-Wandler 14 nachgeschaltet, welcher an seinem Eingang einen Choppermodulator 13 und an seinem Ausgang einen Chopperdemodulator 15 aufweist, die das Signal jeweils gemäß einer Chopperfrequenz fchop choppen (zerhacken). Derartige Choppertechniken dienen insbesondere zur Offsetkompensation eines Offsets des Analog-Digital-Wandlers 14. Der Einfachheit halber werden fchop und fdemod im Folgenden sowohl zum Bezeichnen der Signale als auch zum Bezeichnen der Frequenz der Signale verwendet. Die Frequenz fchop kann dabei an die Demodulationsfrequenz fdemod angepasst sein. So kann die Frequenz fdemod ein ganzzahliges Vielfaches der Frequenz fchop sein, wobei optional zudem Pulse, steigende Flanken oder dergleichen des Signals fdemod mit einem der Pulse, steigenden Flanken und dergleichen des Signals fchop zusammenfallen können. Zudem kann die Frequenz fdemod mit einer Taktfrequenz fclock (entsprechend einer Abtastfrequenz fs), mit der der Analog-Digital-Wandler 14 arbeitet, derart synchronisiert sein, dass fclock ein ganzzahliges Vielfaches von fdemod ist. Dies kann helfen, Schwebungen zu vermeiden.

Ein zeitkontinuierlicher Analog-Digital-Wandler ist im Rahmen der vorliegenden Anmeldung ein Analog-Digital-Wandler, der nicht auf Basis einzelner Abtastwerte an seinem Eingang arbeitet, sondern an seinem Eingang anliegende Signale zumindest für bestimmte Zeitabschnitte kontinuierlich verarbeitet. "Zumindest für bestimmte Zeitabschnitte" meint in diesem Fall, dass bei manchen Ausführungsbeispielen, die später erläutert werden, verschiedene Eingänge mittels Multiplexens abwechselnd verarbeitet werden, wobei Signale, die von einem Eingang her kommen, eben jeweils nur in bestimmten Zeitabschnitten verarbeitet werden, innerhalb dieser Zeitabschnitte jedoch dann zeitkontinuierlich gewandelt werden. In diesem Falle werden zeitkontinuierliche Analog-Digital-Wandler auch als inkrementelle Wandler bezeichnet. Im Folgenden wird zur Vereinfachung vorwiegend der Begriff zeitkontinuierliche Analog-Digital-Wandler verwendet, wobei zu verstehen ist, dass es sich auch um Wandler handeln kann, die nur in manchen Zeitabschnitten zeitkontinuierlich arbeiten, also beispielsweise inkrementelle Wandler sind.

Bei manchen Ausführungsbeispielen wird durch die Verwendung eines passiven Demodulators und/oder eines zeitkontinuierlichen Analog-Digital-Wandlers mit Choppen durch den Choppermodulator 13 und den Chopperdemodulator 15 eine inhärente Tiefpassfilterung erreicht, so dass kein zusätzlicher Tiefpassfilter bereitgestellt werden muss. Zudem ist es durch die Kombination des zeitkontinuierlichen Analog-Digital-Wandlers 14 mit dem Demodulator 12 möglich, dass der Dynamikbereich hinreichend groß zur Verarbeitung der Signale ist, und somit kein Verstärker mit variabler Verstärkung bereitgestellt werden muss. Die Gründe hierfür werden später noch genauer erläutert.

Die Vorrichtung 11 gibt dann ein digitalisiertes Signal sdig aus, welches von nachfolgenden Schaltungen weiterverarbeitet werden kann. Ist die Signalquelle 10 beispielsweise ein Sensor, so repräsentiert das Signal sdig die von dem Sensor erfasste physikalische Größe, und durch Auswertung des Signals sdig können dann beispielsweise Steuerungsprozesse oder Regelungsprozesse auf Basis der physikalischen Größe durchgeführt werden.

Derartige Analog-Digital-Wandler-Vorrichtungen können beispielsweise in Sensorsystemen eingesetzt werden, die induktive Sensoren verwenden. Ein derartiges Sensorsystem gemäß einem Ausführungsbeispiel ist in der Fig. 2 dargestellt.

Ein induktiver Sensor des Systems der Fig. 2 weist eine Anregungsspule 20, eine sich bewegende Induktivität 21 und drei Empfangsspulen 22A, 22B und 22C auf. Die sich bewegende Induktivität 21 kann beispielsweise durch eine geschlitzte Metallscheibe realisiert sein, die an einem Element, dessen Bewegung zu messen ist, befestigt ist. Als Beispiel für das System der Fig. 2 kann dabei ein Rotor beispielsweise eines Elektromotors dienen, an dem die Induktivität 21 angebracht ist.

Ausgangsströme Inu, Inv und Inw der Empfangsspulen 22A, 22B bzw. 22C werden von einer Steuerung 23 empfangen und dort mittels einer Analog-Digital-Wandler-Vorrichtung der Steuerung 23 gemäß einem Ausführungsbeispiel, beispielsweise jeweils der Analog-Digital-Wandler-Vorrichtung 11 der Fig. 1 oder einer der nachfolgend beschriebenen Analog-Digital-Wandler-Vorrichtungen digitalisiert. Zudem weist die Steuerung 23 einen digitalen Signalprozessor (DSP) auf, mit dem die digitalisierten Signale gegebenenfalls weiterverarbeitet werden können. Zudem verfügt die Steuerung 23 über einen Oszillator (nicht dargestellt), mit dem Signale LCiop, LCiun zur Versorgung der Anregungsspule 22 ausgegeben werden. Die Signale LCiop, LCiun sind dabei Signale mit einer relativ hohen Frequenz, beispielsweise größer 1 MHz oder größer 3MHz beispielsweise etwa 3,5 MHz. Die Zuleitungen zu der Anregungsspule 20 sind wie dargestellt über Kondensatoren 24A, 24B mit Masse verbunden. Die Steuerung 23 wird von einer Versorgungsspannung 25 versorgt und ist mit Masse (gnd) gekoppelt.

Im Betrieb wird das hochfrequente Signal LCiop, LCiun, das der Anregungsspule 20 zugeführt und wird durch induktive Kopplung (d.h. durch die Wirkung des von der Anregungsspule 20 erzeugten Magnetfeldes auf die Empfangsspulen 22A, 22B, 22C) in die Empfangsspulen 22A, 22B, 22C eingekoppelt. Die Stärke der Kopplung variiert dabei je nach Position der Induktivität 21, beispielsweise je nach Drehwinkel eines Rotors, an dem die Induktivität 21 angebracht ist. Somit ergeben sich zeitlich variierende Signale Inu, Inv und Inw, aus denen auf die Position der Induktivität 21 und somit des sich bewegenden Elements, beispielsweise des Rotors, rückgeschlossen werden kann. Ein entsprechend ausgegebenes Signal sdig repräsentiert dann die Position des sich bewegenden Elements, beispielsweise die Winkelposition des Rotors.

Durch die variierende Kopplung ergeben sich bei einem Sensor wie in der Fig. 2 dargestellt der vergleichsweise große Dynamikbereich der Signale Inu, Inv, Inw, die über entsprechende Eingangswiderstände dann zu Spannungssignalen beispielsweise im Bereich von 4 bis 120 mV führen können.

Ein derartiger induktiver Sensor wird in mehreren der folgenden Ausführungsbeispiele als Beispiel verwendet. Dies ist jedoch nicht als einschränkend zu verstehen, und es können auch bei den nachfolgend beschriebenen Ausführungsbeispielen andere Arten von Signalquellen als induktive Sensoren verwendet werden.

Die Fig. 3 zeigt ein System gemäß einem weiteren Ausführungsbeispiel.

Bei dem Ausführungsbeispiel der Fig. 3 empfängt eine Vorrichtung zur Analog-Digital-Wandlung gemäß einem Ausführungsbeispiel ein Signal von einer Empfangsspule 30 an Eingangspads 31A, 31B. Die Empfangsspule 30 kann beispielsweise eine der Empfangsspulen 22A, 22B und 22C der Fig. 2 sein. Das Signal von der Empfangsspule 30 wird über Eingangswiderstände 32A, 32B einem Demodulator 30 zugeführt, der das Eingangssignal mit einer Frequenz fdemod mischt und somit demoduliert. Die Frequenz fdemod kann mit der Anregungsfrequenz einer verwendeten Anregungsspule wie der Anregungsspule 20 der Fig. 2 synchron sein und/oder dieser entsprechen. Insbesondere kann fdemod einer Frequenz fLC entsprechen. fLC ist eine Resonanzfrequenz eines LC-Schwingkreises, der durch eine verwendete Anregungsspule wie die Anregungsspule 20 der Fig. 2, zusammen mit externen Kapazitäten auf der Leiterplatte, z.B. 3.5MHz gebildet wird. Diese Resonanzfrequenz wird bei verschiedenen Ausführungsbeispielen also auch zum Demodulieren benutzt, also fLC=fdemod. Hierfür wird bei verschiedenen Ausführungsbeispielen ein Spannungsnulldurchgang der sinusförmigen LC-Schwingung des LC-Schwingkreises zum Schalten der digitalen fdemod-Frequenz genommen, damit Frequenz und Phase zur Demodulation passt.

Die Eingangswiderstände 32A, 32B können beispielsweise Widerstandswerte zwischen 100 Ω und 1 MΩ, beispielsweise zwischen 300 und 500 Ω, beispielsweise ungefähr 400 Ω aufweisen.

Ein Spannungswert, der dem demodulierten Eingangssignal entspricht, liegt dann an einem Kondensator 34 an und wird dort zeitlich gemittelt. Bei sich nicht ändernder Eingangsamplitude des von der Empfangsspule 30 empfangenen Signals stellt sich an dem Kondensator 34 ein DC-Mittelwert ein zuzüglich einer überlagerten AC-Restspannung, da ja die Filterung der doppelten Modulationsfrequenz (nach Gleichrichtung) nicht besonders hoch ist. Dahingegen wird an weiter unten diskutierten Kondensatoren 310A und 310B das Eingangsignal tasächlich integriert.

Kondensatoren 35A und 35B repräsentieren Kapazitäten zu Masse, einschließlich parasitärer Kapazitäten. Die Demodulation erfolgt bei dem Ausführungsbeispiel der Fig. 3 also wie bei dem Ausführungsbeispiel der Fig. 1 ohne Verstärkung, insbesondere ohne eine variable Verstärkung. Die Eingangswiderstände 32A, 32B zusammen mit dem Kondensator 34 ergeben ein RC-Filter, welches ein Tiefpassverhalten aufweist. Daher muss kein zusätzliches Tiefpassfilter vorgesehen werden, da auf diese Weise eine Tiefpassfilterung zum Herausfiltern hochfrequenter Störsignale erreicht werden kann.

Das so demodulierte Signal wird dann einem Choppermodulator 36 zugeführt, welcher mit einer Frequenz fchop arbeitet, die wie bereits oben unter Bezugnahme auf Fig. 1 erläutert synchron zu der Frequenz fdemod läuft. Beispielsweise kann fdemod ein ganzzahliges Vielfaches von fchop sein. Zudem kann fdemod gleich der oben erwähnten Frequenz fLC sein.

So wird eine gechoppte Eingangsspannung Vin für einen zeitkontinuierlichen Sigma-Delta-Analog-Digital-Wandler (CT-∑-Δ-ADC) 37 bereitgestellt. Hier kann jede herkömmliche Implementierung eines zeitkontinuierlichen Sigma-Delta-Wandlers verwendet werden. Bei dem Ausführungsbeispiel der Fig. 3 weist der zeitkontinuierliche Sigma-Delta-Analog-Digital-Wandler 37 einen Integrator auf, welcher Kondensatoren 310A, 310B benutzt. Diese Kondensatoren 310A, 310B sind über einen Chopper 39, welcher ebenfalls mit der Chopperfrequenz fchop betrieben wird, mit dem restlichen Wandler verbunden. An den Kondensatoren 310A, 310B erfolgt beispielsweise die Integration eines Stroms, der durch eine Spannungs-Strom-Wandlung in der Eingangsstufe des Analog-Digital-Wandlers 37 integriert. Dies bedeutet, dass eine DC-Eingangsspannung am Eingang des Analog-Digital-Wandlers 37 an den Kapazitäten 310 zu einer unendlich anwachsenden integrierten Spannung führen würde. Der in Sigma-Delta-Analog-Digital-Wandlern enthaltene Digital-Analog-Wandler verhindert das jedoch durch eine Gegenkopplung, wie später näher beschrieben, da das Vorzeichen der Spannung im Komparator bei jeder Analog-Digital-Wandlung über die Integrationsrichtung des Wandlers entscheidet.

Ein von dem zeitkontinuierlichen Sigma-Delta-Analog-Digital-Wandler 37 ausgegebenes Signal wird in einem Chopperdemodulator 38 ebenfalls mit der Chopperfrequenz fchop demoduliert, was im digitalen Fall einer Multiplikation abwechselnd mit +1 und -1 entspricht.

Der zeitkontinuierliche Sigma-Delta-Analog-Digital-Wandler weist bei manchen Ausführungsbeispielen, wie dies später unter Bezugnahme auf Fig. 8 noch detaillierter erläutert werden wird, eine vergleichsweise hohe Eingangsimpedanz, beispielsweise >100 Ω, beispielsweise im Bereich 250 Ω, auf und weist wie bei Sigma-Delta-Wandlern üblich eine Rückkopplungsschleife auf.

Als Ausgangssignale kann beispielsweise ein 6-Bit-Signal mit einer Ausgangsfrequenz von 10 MHz ausgegeben werden, wobei auch andere Bitbreiten und Frequenzen möglich sind.

Die Wirkungsweise des Demodulators 33 und der Kapazität 34 wird nunmehr unter Bezugnahme auf die Fig. 4 und 5 erläutert.

Die Fig. 4 zeigt das Eingangssignal für den Choppermodulator 36 für verschiedene Filtereinstellungen des durch die Widerstände 32A, 32B und den Kondensator 34 gebildeten Tiefpassfilters. Als Modulationsfrequenz des Eingangssignals (entsprechend der Frequenz der Anregungsspule 20 der Fig. 2 zugeführten Signals LCiop, LCion) wurde dabei 3,5 MHz angenommen.

Die Kurve 40 zeigt ein Signal ohne Kapazität 34, das heißt ohne Tiefpassfilterung. Eine Kurve 41 zeigt ein Signal mit einer Eckfrequenz des Tiefpassfilters von 3,5 MHz, und eine Kurve 42 zeigt ein Beispielsignal bei einer Eckfrequenz von 1 MHz. Dabei wurde eine konstante Signalamplitude von der Empfangsspule 30 angenommen. Wie zu sehen ist, schwingt sich das Signal bei einer Filterung um einen stationären Wert herum ein, der dem zu wandelnen Signalwert entspricht.

Die Demodulation ist zudem in Fig. 5 veranschaulicht. In der Fig. 5 zeigt eine Kurve 51 ein Beispiel für ein Eingangssignal für den Demodulator 33, das heißt für ein von der Empfangsspule 30 geliefertes Signal. Eine Kurve 52

zeigt ein Beispiel für das Signal mit der Frequenz fdemod, welches dem Demodulator 33 zugeführt wird. Eine Kurve 50 zeigt ein Eingangssignal für den Chopper 36, welches durch die Demodulation mit Filterung durch den Kondensator 34 und die Widerstände 32A, 32B erzeugt wurde.

Im Folgenden werden nun die Vorteile und Effekte der Verwendung eines zeitkontinuierlichen Analog-Digital-Wandlers wie des zeitkontinuierlichen Sigma-Delta-Analog-Digital-Wandlers 37 der Fig. 3 gegenüber einem Analog-Digital-Wandler, welcher geschaltete Kondensatoren zum Abtasten eines Eingangssignals verwendet und somit nicht zeitkontinuierlich arbeitet, erläutert. Zur Veranschaulichung zeigt die Fig. 6 ein schematisches Schaltbild einer Eingangsstufe eines zeitkontinuierlichen Analog-Digital-Wandlers, und die Fig. 7 zeigt ein schematisches Schaltbild einer Eingangsstufe eines Analog-Digital-Wandlers mit geschaltetem Eingangskondensator.

Bei der Fig. 6 repräsentiert eine Spannungsquelle 62 die Erzeugung einer Eingangsspannung Vs für den Wandler. Diese wird einem Eingangsverstärker 60, der eine Transkonduktanz gm aufweist, zugeführt. Der Eingangsverstärker 60 ist dabei durch ein Transistorpaar 63A, 63B, Stromquellen 64A, 64B, die jeweils einen Strom Id erzeugen, einer Stromquelle 65 sowie einer Stromquelle 66 repräsentiert, die das Ausgangssignal des Verstärkers 60 ausgibt. Diese Darstellung ist nur als schematisch zu verstehen. Das Ausgangssignal wird einer Integrationskapazität 67 integriert, die einen Wert Cint aufweist.

Um ein niedriges Rauschen zu erzeugen, muss die inverse Transkonduktanz 1/gm < der Widerstandswert Rs des Eingangswiderstandes 61 sein. So ist beispielsweise für eine Rauschkennzahl NF (vom englischen noise figure) von +1 dB erforderlich, das die Transkonduktanz der Eingangsstufe folgende Beziehung erfüllt:

$$\frac{1}{gm} <\approx \tfrac{1}{2}\, Rs$$

Um das Rauschen zu optimieren, müssen die Transistoren 63A, 63B in schwacher Inversion betrieben werden, um ein möglichst gutes Verhältnis von gm zu dem Strom Id zu erhalten. In diesem Fall wird 1/gm zu

$$\frac{1}{gm} = \left(\frac{kT}{q}\right) \frac{n}{0.7} \frac{1}{Id} \approx \frac{55\mathrm{mV}}{Id}$$

wobei hier n als der technologieabhängige Faktor, um den die Transistoren unterhalb der Schwelle des Schwellenwertes betrieben werden (das heißt in schwacher Inversion) auf 1,4 gesetzt wurde, Id der Strom durch die Transistoren 63A, 63B ist, k die Boltzmann-Konstante ist, T die absolute Temperatur ist und q die Elementarladung ist. Als Temperatur T wurde für den Ausdruck auf der rechten Seite Raumtemperatur angenommen. Für einen Eingangswiderstand Rs von 1 k$\Omega$ muss Id dann größer als etwa 110 $\mu$A sein, was für eine Eingangsstufe eines zeitkontinuierlichen Sigma-Delta-Analog-Digital-Wandler oder einen Verstärker durch entsprechendes Design relativ leicht zu erfüllen ist.

Die Fig. 7 zeigt eine Eingangsstufe eines Analog-Digital-Wandlers mit einem Eingangskondensator 73. Eine Eingangsspannung Vs wird von einer Spannungsquelle 79 über einen Eingangswiderstand 71 bereitgestellt. In einer ersten Betriebsphase sind Transistorschalter 72A, 72B gesteuert durch ein Signal Ph1 geschlossen, so dass in Abhängigkeit von der Eingangsspannung der Eingangskondensator 73 geladen wird, während Transistorschalter 74A, 74B gesteuert durch ein Signal Ph2 geöffnet sind. In einer zweiten Phase werden dann die Transistorschalter 72A, 72B geöffnet, und die Transistorschalter 74A, 74B werden geöffnet, um so die Ladung zu einem Eingang eines Verstärkers 70 zu übertragen. Der Verstärker 70 weist ähnlich dem Verstärker 60 der Fig. 6 ein Eingangstransistorpaar 76A, 76B mit zugehörigen Stromquellen 77A, 77B, 78 auf. Ein Ausgangssignal des Verstärkers 70 wird weiterverarbeitet (nicht dargestellt) und über einen Kondensator 75 auf einen Eingang des Verstärkers 70 rückgekoppelt. Wiederum ist die Darstellung der Fig. 7 nur als schematisch zu verstehen.

Bei einem derartigen Wandler ist die Dimensionierung einer Kapazität Cin des Eingangskondensators 73 insofern eine Herausforderung, als dass es hier widerstreitende Anforderungen gibt. Einerseits muss die Kapazität Cin klein genug gewählt werden, damit ein Einschwingen des Wandlers nötig ist. Um das Nyquist-Kriterium zu erfüllen, muss die Abtastfrequenz fs entsprechend einer zum Abtasten verwendeten Taktfrequenz fclock, die den Signalen Ph1, Ph2 zu Grunde liegt, viel größer als die Bandbreite des abzuwandelnden Signals sein. Um ein korrektes Einschwingen während eines Abtastzeitraums zu gewährleisten, muss innerhalb einer Zeitspanne Ts/2, wobei Ts das Inverse eines verwendeten Taktsignals fclock (die wie oben erläuter gleich der Abtastfrequenz fs ist, d.h. Ts ist damit auch das Inverse der Abtastfrequenz fs) ist ein Vielfaches einer Zeitkonstanten $\tau$ = Rs x Cin sein, wobei Rs der Widerstandswert des Eingangswiderstandes 71 ist. Beispielsweise ist für eine Genauigkeit von 12 Bit 8,4 $\tau$ innerhalb von Ts/2 erforderlich, für 8 Bit 5,6 $\tau$. Dies führt zu

$$8{,}4 R_s C_{in} \leq \tfrac{1}{2}\, T_s = 1/(2 f_{clock})$$

$$C_{int} \leq 1/(2 \times f_{clock}\, R_s)$$

$$R_{noise_equi} = 1/(f_{clock}\, C_{int}) \geq 16{,}8\, R_s$$

Dabei ist Cint der Kapazitätswert des Kondensators 75 der Fig. 7. Dies führt zu 16,8 mal höherem Rauschbeitrag der Impedanz der Kondensatoren unabhängig von der Taktfrequenz oder der Leistungszufuhr an die Eingangstransistoren 76A, 76B.

Die Rauschkennzahl NF für ein 12-Bit-Signalist begrenzt auf

$$NF(12bit) = 20 \cdot log10\left(\sqrt{(1 + 2 \cdot 8{,}4)}\right) = 12{,}5dB$$

$$NF(8bit) = 20 \cdot log10\left(\sqrt{(1 + 2 \cdot 5{,}6)}\right) = 10{,}9dB$$

Dies bedeutet, dass mit einem zeitkontinuierlichen Analog-Digital-Wandler, wie er bei Ausführungsbeispielen verwendet wird, ein drei- bis viermal niedrigeres Rauschen erreicht werden kann als mit Wandlern, die mit geschalteten Kapazitäten arbeiten.

Zudem kann die Verarbeitung mit zeitkontinuierlichen Analog-Digital-Wandlern Effekte durch Signalfaltung (aliasing), wie sie bei Analog-Digital-Wandlern, welche ein Abtasten beispielsweise mit geschalteten Kapazitäten wie in Fig. 7 gezeigt verwenden, auftreten können. Dies kann Rauschen und Spiegelfrequenzen durch Signalfaltung verringern und einen Dynamikbereich zu Signalen kleinerer Amplituden hin vergrößern.Spiegelfrequenzen entstehen dadurch, dass sich Signale mit Frequenzen außerhalb des Nutzfrequenzbereichs unerwünschterweise in den Nutzfrequenzbereich spiegeln. So kann z.B. ein Eingangsstörsignal um 3x fdemod+4kHz wird nach der Demodulation als zusätzliches unerwünschtes 4kHz-Signal sichtbar. Derartige Effekte können bei Ausführungsbeispielen verringert werden.

Wie oben erläutert, brauchen zeitkontinuierliche Analog-Digital-Wandler nicht ein Vielfaches der oben erwähnten Zeit $\tau$ innerhalb von Ts/2, um einzuschwingen. Dies reduziert die zum Einschwingen notwendige Bandbreite und damit das Rauschen und die benötigte Leistung, da je größer die benötigte Bandbreite ist, desto größer die notwendige elektrische Leistung ist, um eine benötigte Geschwindigkeit zum Einschwingen zu erreichen.

Das Verwenden von Choppern in Verbindung mit einem zeitkontinuierlichen Analog-Digital-Wandler kann weiterhin einen Offset um ein bis drei Größenordnungen verringern. Zudem kann diese Kombination Flickerrauschen, das zu tieferen Frequenzen hin ansteigt und durch aktive elektronische Schaltungen und gechoppte Widerstände verursacht wird, verringern. Zudem können bei manchen Ausführungsbeispielen geradzahlige harmonische Verzerrungen verringert werden.

Der Dynamikbereich kann dann, wie weiter unten erläutert werden wird, in zeitkontinuierlichen Sigma-Delta-Wandlern durch ein Multi-Bit-Feedback oder durch Rückkopplungsschleifen, um einen Offsetwelligkeiten zu kompensieren, auch nach oben vergrößert werden. Durch den vergrößerten Dynamikbereich bei verschiedenen Ausführungsbeispielen wird kein Verstärker mit variabler Verstärkung benötigt, und es kann eine direkte passive Demodulation mit dem Demodulator 12 der Fig. 1 oder dem Demodulator 32 der Fig. 3 erfolgen, ohne dass eben ein derartiger variabler Verstärker notwendig ist. Dies kann bei manchen Ausführungsbeispielen einen Offset, der von einem derartigen Verstärker verursacht werden kann, verringern, Einschwingprobleme reduzieren und/oder das Rauschen bei manchen Ausführungsbeispielen verringern.

Zudem kann bei manchen Ausführungsbeispielen die Kombination aus den Eingangswiderständen 32A, 32B und dem Kondensator 34 als Filter gegenüber den elektromagnetischen Störungen (EMC-Filter, electromagnetic compliance) dienen und kann Intermodulationsprobleme, welche durch Nichtlinearitäten aktiver Schalter wie Verstärkungen entstehen würden, vermeiden. Die Eingangswiderstände 32A, 32B können zusätzlich zum Schutz vor elektrostatischen Entladungen (ESD-Schutz) dienen. Die Eingangswiderstände können also bei zeitkontinuierlichen Wandlern gut an Rauschbedingungen angepasst werden, und die Signalverarbeitung kann leicht auf eine anspruchsvolle Rauschzahl, beispielsweise nur zusätzlich +1 dB wie oben erläutert, angepasst werden.

Die Schwingungen, die in Fig. 4 gezeigt werden, können wie dargestellt zum einen durch die Tiefpasseigenschaften des zeitkontinuierlichen Wandlers verringert werden. Bei größeren Tiefpassfrequenzen verbleibt eine Schwingung, deren Frequenz sich hauptsächlich aus der Taktfrequenz des Analog-Digital-Wandlers fclock minus der oben erwähnten Frequenz fLC bestimmt.

Wenn die Frequenz fADC auf fLC synchronisiert wird, kann diese Schwingung ebenfalls verringert werden.

Die Fig. 8 zeigt ein weiteres Ausführungsbeispiel einer Vorrichtung gemäß einem Ausführungsbeispiel. Elemente, die bereits unter Bezugnahme auf die Fig. 3 erläuterten Elementen entsprechen, tragen die gleichen Bezugszeichen und werden nicht nochmals näher erläutert. In der Fig. 8 wird insbesondere ein nicht einschränkendes Beispiel für einen Aufbau des zeitkontinuierlichen Sigma-Delta-Analog-Digital-Wandlers 37 der Fig. 3 dargestellt.

Der Analog-Digital-Wandler der Fig. 8 weist einen Spannungs/Stromwandler 80 auf (z.B. Transkonduktanzverstärker), in den über einen Eingangswiderstand 81 ein Rückkopplungssignal des Analog-Digital-Wandlers rückgekoppelt wird. Ausgangsströme des Spannungs/Stromwandlers 80 werden mittels Kondensatoren 310A, 310B analog integriert. Die Kondensatoren 310A, 310B können in diesem Fall beispielsweise mittels Gateoxiden realisiert sein.

Das so integrierte Stromsignal wird einem Komparator 82 zugeführt. Ein Ausgang des Komparators wird dem Chopperdemodulator 38 zugeführt, welcher in diesem Fall innerhalb der Schleife des Sigma-Delta-Wandlers angeordnet ist, aber auch bei dieser Anordnung die Chopperdemodulation des Ausgangssignals bewirkt. Das Ausgangssignal des Komparators 82, das einer +1 oder einer -1 entspricht, wird einem digitalen Integrator 83 zugeführt. Dieser entspricht einem Zähler, der nach oben zählt, wenn das Ausgangssignal des Komparators 82 einer +1 entspricht, und nach unten zählt, wenn das Ausgangssignal des Komparators 82 einer -1 entspricht.

Zudem wird mittels eines Zählers 85 das um +1 vergrößerte Ausgangssignal des Komparators 82 in einem Addierer 84 zu einem Ausgangssignal des Integrators 83 hinzu addiert. Der Addierer 84 ist dabei eine digitale Summationsstelle, die den digital integrierten Wert aus dem Integrator 83 mit dem "schnelleren" "Proportional-" oder "Vorwärts-" Wert des Komparators über 85 addiert. Es erfolgt also eine Summation eines schnellen Sofortwerts aus 85 mit einem durch Integration verzögertem Wert aus dem Integrator 83. Der Pfad über 85 kann als stabilisierender Proportional-Vorwärts-Pfad ähnlich wie bei z.B PID-Reglern oder stabilisiernde Nullstelle im Bode-Diagramm bei rückgekoppelten Systemen verstanden werden.Ohne den Pfad 85 können bei manchen Anwendungen unerwünschte Schwingungen auftreten.

Auf diese Weise wird ein thermometercodiertes Digitalsignal erzeugt, das die Eingangsspannung Vin an dem Spannungs- /Stromwandler 80 repräsentiert. Dieses Signal kann durch einen Thermometer-/Binärcodierer 86 in ein binäres Ausgangssignal umgewandelt werden. Das thermometercodierte Signal kann beispielsweise ein 64 Bit thermometercodiertes Signal sein.

Das thermometercodierte Signal wird zudem über einen Digital-Analog-Wandler 87 als Rückkopplungssignal in den Spannungs/Stromwandler 80 rückgekoppelt. Der Digital-Analog-Wandler 87 ist dabei in dem dargestellten Ausführungsbeispiel ein Multibit-Digital-Analog-Wandler, der das thermometercodierte 64 Bit-Signal rückgekoppelt. Durch derartige Multibit-Digital-Analog-Wandler kann ein Dynamikbereich des Sigma-Delta-Analog-Digital-Wandlers bei manchen Ausführungsbeispielen vergrößert werden.

Die Implementierung als Sigma-Delta-Analog-Digital-Wandler ist nur als Beispiel zu verstehen, und es können auch andere Wandler wie SAR-Wandler (successive approximation register, Nachverfolgungswandler (Tracking-ADCs) oder andere zeitkontinuierliche Wandler verwendet werden.

Während in Fig. 8 nur ein einzelner Spannungs/Stromwandler 80 dargestellt ist, können bei anderen Ausführungsbeispielen auch mehrere Spannungs/Stromwandler 80 bereitgestellt sein, die wahlweise parallel geschaltet werden können. Dies kann insbesondere bei kleinen Eingangssignalen die Transkonduktanz vergrößern und somit das Rauschen verringern. Die Parallelschaltung kann dabei bei bei manchen Ausführungsbeispielen nur bei kleinen Eingangssignalen, z.B. mit einem Spannungs- oder Strompegel unterhalb einem vorgegebenen Schwellenwert, erfolgen, während bei größeren Eingangssignalen nur ein Spannungs/Stromwandler genutzt wird. Hierdurch kann in Kombination mit dem beschriebenen Choppen bei manchen Ausführungsbeispielen auch bei kleinen Eingangssignalen eine entsprechende Verstärkung erzielt werden, ohne dass hierdurch wesentliche Offset- und Linearitätsfehler verursacht werden.

Bei manchen Anwendungen wie dem induktiven Sensor der Fig. 2 ist es nötig, mehrere Eingangssignale analog/digital zu wandeln, im Falle der Fig. 2 drei Eingangssignale Inu, Inv, Inw.

Bei manchen Ausführungsbeispielen kann hierzu für jedes Eingangssignal eine Vorrichtung wie in Fig. 3 oder wie in Fig. 8 gezeigt bereitgestellt werden. Bei anderen Ausführungsbeispielen kann eine einzige Analog-Digital-Wandler-Vorrichtung bereitgestellt werden, welche über einen Multiplexer 90 die verschiedenen Eingangssignale abwechselnd verarbeitet. Ein Beispiel für eine derartige Vorrichtung ist in der Fig. 9 dargestellt.

Bei dem Ausführungsbeispiel der Fig. 9 wird ein Signal eines induktiven Sensors, beispielsweise des induktiven Sensors der Fig. 2, verarbeitet, welcher drei Erfassungsspulen 30A, 30B und 30C aufweist. Die Erfassungsspule 30A ist mit Eingangspads 31A, 31B der dargestellten Analog-Digital-Wandler-Vorrichtung verbunden, die Erfassungsspule 30B ist mit Eingangspads 31C, 31D verbunden, und die Erfassungsspule 30C ist mit Eingangspads 31E, 31F verbunden. Die Eingangspads 31A bis 31F sind mit einem Multiplexer 90 verbunden, welcher eingerichtet ist, Signale von einer der Erfassungsspulen 30A bis 30C zur weiteren Verarbeitung auszuwählen.

Der Multiplexer 90 wird mit einer Frequenz fADC betrieben, welcher bestimmt, in welchen Zeitintervallen zwischen den Signalen von den verschiedenen Erfassungsspulen 30A bis 30C umgeschaltet wird.

Das ausgewählte Signal wird einem Demodulator 92 zugeführt, dessen Funktion dem Demodulator 33 der Fig. 3 entspricht, wobei ein entsprechendes Demodulationsignal mit der Frequenz fdemod von einer Oszillatoreinrichtung 91 zugeführt wird. Dem Demodulator 92 nachgeschaltet ist ein Tiefpassfilter 93 dargestellt, welches auch wie bei vorher diskutierten Ausführungsbeispielen durch Eingangswiderstände (beispielsweise 32A, 32B der Fig. 3) und eine Kapazität (beispielsweise 34 der Fig. 3) gebildet sein kann. Ein Ausgang des Tiefpassfilters 93 ist mit einem Eingang eines inkrementellen Analog-Digital-Wandlers 95 verbunden. Der inkrementelle Analog-Digital-Wandler ist im Wesentlichen ein zeitkontinuierlicher Wandler, der jedoch nur in Abschnitten zeitkontinuierlich arbeitet, nämlich in Abschnitten, während denen jeweils das Eingangssignal von einer Erfassungsspule 30A bis 30C, verarbeitet wird. Der inkrementelle Analog-Digital-Wandler 95 weist einen Choppermodulator 96 an seinem Eingang und einen Chopperdemodulator 97, der hier am Ausgang dargestellt ist, aber auch wie in Fig. 8 gezeigt innerhalb des Wandlers angeordnet sein kann, auf.

Als inkrementeller Analog-Digital-Wandler 95 können die oben genannten Wandlertypen verwendet werden. Beispielsweise kann ein SAR-Wandler in Kombination mit einem Nachverfolgungswandler verwendet werden.

Auch Kombinationen verschiedener Wandler sind möglich. Das Tiefpassfilter 93 kann auch ein inhärenter Tiefpassfilter des Analog-Digital-Wandlers 95 sein.

Der Tiefpassfilter und der inkrementelle Analog-Digital-Wandler werden entsprechend der Frequenz fADC, mit der der Multiplexer 90 betrieben wird, zurückgesetzt (reset), so dass gleichsam für jeden Abschnitt, in dem das Signal von einer der Empfangsspulen 30A bis 30C verarbeitet wird, ein "Neustart" erfolgt. Dem inkrementellen Analog-Digital-Wandler 95 kann dabei ein vorheriger Wert als Startwert zugeführt werden, der einem Endwert eines vorherigen Zeitabschnitts für die jeweilige Empfangsspule entspricht. Alternativ kann prev auch ein vorhergesagter Wert sein, der aus einem vorherigen Verlauf abgeleitet wird. Dies wird unter Bezugnahme auf die Fig. 13 erläutert.

In Fig. 13 zeigt eine Kurve mit Kurvensegmenten 1300A-C und 1301A-C einen Verlauf eines zu digitalisierenden Eingangssignals. In den Abschnitten 1300A, 1300B und 1300C wird das entsprechende Eingangssignal dem Analog-Digital-Wandler zugeführt (beispielsweise ist das Eingangssignal ein von der Empfangsspule 30A erzeugtes Signal und wird über den Multiplexer 90 ausgewählt), während in den Abschnitten 1301A, 1301B und 1301C keine Digitalisierung erfolgt (beispielsweise weil das Signal einer anderen Empfangsspule von dem Multiplexer 90 ausgewählt wird). Zu Beginn des Abschnitts 1300A ist, wie mit dem Bezugszeichen 1303A gekennzeichnet, ein Einschwingvorgang erforderlich, bis das digitale Ausgangssignal sich auf den richtigen Wert einschwingt. Wenn, wie für den Abschnitt 1300B gezeigt, der Wert am Ende des Abschnitts 1300A als Startwert verwendet wird, ist ebenfalls ein Einschwingvorgang erforderlich, wie mit dem Bezugszeichen 1303B gekennzeichnet. Daher werden bei manchen Ausführungsbeispielen Vorhersagetechniken verwendet, wie durch Pfeile 1302A und 1302B angedeutet. Hier wird nicht nur der Endwert des vorherigen Abschnittes herangezogen, sondern auch ein Verlauf in einem oder mehreren vorhergegangenen Abschnitten. Beispielsweise kann in einem einfachen Fall eine mittlere Steigung der vorherigen Abschnitte verwendet werden, um einen Verlauf und somit einen Startwert anzupassen. Bei anderen Ausführungsbeispielen können Vorhersagetechniken verwendet werden. Beispielsweise kann eine lineare, quadratische oder sinusförmige Fitkurve an vorherige Abschnitte gelegt werden und hieraus ein Startwert bestimmt werden.

Als weitere Alternative kann ein Analog-Digital-Wandler zwischen verschiedenen Betriebsarten oder Typen von Analog-Digital-Wandlern umgeschaltet werden. Beispielsweise kann zu Beginn jedes Abschnitts 1300A, 1300B, 1300C zunächst eine SAR-Analog-Digital-Wandlung stattfinden, um schnell zu einem entsprechenden Startwert zu gelangen, und dann beispielsweise mit einem Sigma-Delta-Wandler eine Nachverfolgung des Wertes stattfinden, um Änderungen des Eingangswerts abzubilden.

Wiederum auf die Fig. 9 Bezug nehmend kann des Weiteren eine Bereichsauswahleinrichtung 94 bereitgestellt sein, mit der über ein Signal RF ein Eingangsbereich für den inkrementellen Wandler 95 ausgewählt werden kann, beispielsweise durch Setzen eines Referenzwertes. Auf diese Weise kann ein Bereich, in dem Eingangssignale gewandelt werden können, vergrößert werden. Diese Auswahl eines Eingangsbereichs wird durch einen zusätzlichen Eingang des inkrementellen Wandlers 95 wie dargestellt erreicht, und nicht wie bei manchen herkömmlichen Lösungen durch eine fehlerträchtige Zusatzschaltung vor der Eingangsstufe inkrementellen Wandlers 95 wie einem Verstärker mit variabler Verstärkung. So können bei manchen Ausführungsbeispielen z.B Offset-Fehler reduziert werden, und unvermeidliche Offset- Rausch- und Einschwingvorgänge vorgelagerter gechoppter oder nichtgechoppter Verstärker werden vermieden.

Eine solche Bereichsumschaltung kann auf einfache Weise durch eine Transkonduktanz-Umschaltung der Eingangsstufe des inkrementellen Wandlers 95 erreicht werden. Die Spannungs-Stromwandlung der Eingangsstufe kann also um Faktoren umgeschaltet werden. Zudem oder alternativ kann der Full-Scale-Bereich eines Digital-Analog-Wandlers in einem Rückkopplungspfad des inkrementellen Wandlers 95 (siehe vorherige Ausführungsbeispiele) oder eine Referenz des Digital-Analog-Wandlers umgeschaltet werden. Dies bewirkt auch eine Skalenänderung von LSB/V (Least Significant Bit pro Volt Eingangsspannung) am Ausgang des inkrementellen Wandlers 95. Auch wenn diese Bereichsauswahl unter Bezugnahme auf den in Fig. 9 dargestellten inkrementellen Wandler 95 diskutiert wurde, kann sie auch bei den zeitkontinuierlichen Wandlern der anderen hier beschriebenen Ausführungsbeispiele bereitgestellt sein.

Durch das Bereitstellen eines Choppermodulators und Chopperdemodulators kann eine Chopperwelligkeit, auch als Chopper-Ripple bezeichnet, in einem Ausgangssignal entstehen. Derartige Welligkeiten können durch Rückkopplungspfade kompensiert werden. Ein entsprechendes Ausführungsbeispiel ist in der Fig. 10 gezeigt. Wiederum sind Komponenten, die bereits unter Bezugnahme auf vorhergehende Figuren beschrieben worden, mit den gleichen Bezugszeichen gekennzeichnet und werden nicht wiederholt detailliert erläutert.

Ein erstes Eingangssignal wird über Eingangspads 31A, 31B zugeführt, und von dort über Eingangswiderstände 32A, 32B einem Demodulator 33A zugeführt, welcher mit einer Frequenz fdemod läuft und dem Demodulator 33 der Fig. 3 entspricht. Dem Demodulator 33A nachgeschaltet ist eine Kapazitätsanordnung 1000A, deren Funktion der Kapazität 34 und den Kapazitäten 35A, 35B der Fig. 3 entspricht.

In entsprechender Weise kann ein zweites Eingangssignal über Pads 31C, 31D und Eingangswiderständen 32C, 32B einem Demodulator 33B zugeführt werden, dem eine Kapazitätsanordnung 1000B nachgeschaltet ist.

Die so verarbeiteten Signale werden einem kombinierten Multiplexer und Choppermodulator zugeführt, wobei die Multiplexerfunktion mit dem Bezugszeichen 1001 und die Choppermodulatorfunktion entsprechend der Fig. 3 mit dem Bezugszeichen 36 gekennzeichnet ist. Die Funktion des Choppermodulators ist ja im Wesentlichen eine Multiplikation mit +1 oder -1, was einem wahlweise Vertauschen der Eingänge entspricht. Um zusätzlich eine Multiplexerfunktion zu integrieren, kann dieses Vertauschen auf alle Eingänge (im Falle der Fig. 10) ausgeweitet werden. Das heißt, wenn das über die Pads 31A, 31B zugeführte Signal verarbeitet wird, wird das Signal dann letztendlich mit gleicher oder vertauschter Polarität (vertauschten Leitungen) einem Spannungs-/Stromwandler 80, der dem Spannungs-/Stromwandler 80 der Fig. 8 entspricht, zugeführt, und wenn das an den Pads 31C, 31D zugeführte Signal verarbeitet wird, werden diese entsprechenden Signale entweder direkt oder vertauscht dem Spannungs-/Stromwandler 80 zugeführt.

Der Multiplexer wird dabei mit einer Frequenz fADC entsprechend der Fig. 7 betrieben, und der Modulator (das heißt das Vertauschen der Leitungen) mit einer Frequenz fchop.

Die Signale werden dann mit einem zeitkontinuierlichen Sigma-Delta-Analog-Digital-Wandler gewandelt, dessen Aufbau zunächst demjenigen der Fig. 8 entspricht, und einander entsprechende Elemente tragen die gleichen Bezugszeichen. Ein Integrator 1002, der mit einer Frequenz Fclkl betrieben wird, entspricht im Wesentlichen dem Integrator 83 der Fig. 8 und kann beispielsweise als Hoch/Runterzähler implementiert sein. Die Elemente 84 und 85 der Fig. 8 können auch hier bereitgestellt sein. In dem Ausführungsbeispiel der Fig. 10 ist zudem ein Kerbfilter 1003 am Ausgang bereitgestellt.

Im Gegensatz zu dem Ausführungsbeispiel der Fig. 8 weist das Ausführungsbeispiel der Fig. 10 zwei Rückkopplungspfade 1011, 1012 auf, die letztendlich das dem Digital-Analog-Wandler 87 zugeführte Rückkopplungssignal erzeugen.

Der erste Rückkopplungspfad 1011 entspricht hinsichtlich seiner Funktion im Wesentlichen der Rückkopplung der Fig. 8, wobei eine Addition 1005 der Addition 85 und ein Addierer 1006 dem Addierer 84 entspricht, so dass an einem Ausgang des Addierers 1006 ein thermometercodiertes Signal vorliegt. Dieses Signal wird in einem Choppermodulator 1007 mit der Chopperfrequenz fchop gechoppt und einem Addierer 1008 zugeführt.

Der zweite Rückkopplungspfad 1012 umfasst eine Demodulationseinrichtung 1009 zusammen mit einem digitalen Sigma-Delta-Modulator 1010. Die Demodulation 1009 führt eine Zwei-Phasen-Demodulation basierend auf der Chopperfrequenz durch und erzeugt zusammen mit dem digitalen Sigma-Delta-Modulator 1010 ein Offsetsignal, beispielsweise ein Vier-Bit-Offsetsignal, welches Welligkeiten durch das Choppen zumindest teilweise kompensiert. Diese Technik ist für sich genommen bekannt. Somit enthält das dem Digital-Analog-Wandler 87 zugeführte Signal noch eine Komponente, die Welligkeiten durch das Choppen kompensiert.

Eine optionale Bit-Rotation 1013 kann Offsets durch Techniken der dynamischen Zuordnung (dynamic element matching) zusätzlich reduzieren. Dabei ist die Bit-Rotation eine von vielen für sich genommen bekannten Möglichkeiten, um die Nichtlinearität von Wandlern im zeitlichen Mittel auszugleichen. Es können auch andere herkömmliche Verfahren hierzu verwendet werden.

Derartige Techniken können auch an anderer Stelle verwendet werden. Ein Ausführungsbeispiel, welches eine derartige variable Zuordnung von Elementen verwendet, wird nun unter Bezugnahme auf die Fig. 11 beschrieben.

Hier kann beispielsweise ein Referenzstrom, ein Verstärker oder ein Widerstand eines Erfassungswiderstandes 81 zur Bereichsauswahl eingeschränkt werden.

Bei dem Ausführungsbeispiel der Fig. 11 werden die bereits diskutierten Empfangsspulen 22A, 22B und 22C sowie eine Anregungsspule 20 bereitgestellt. Die Induktivität 21 ist nicht dargestellt und lediglich durch ein Transformatorkopplungssymbol in der Fig. 11 repräsentiert.

Die Anregungsspule 20 wird von einem Oszillator 1101 mit einem Anregungssignal versorgt, wobei die bereits diskutierten Kondensatoren 24A, 24B an den Leitungen von dem Oszillator 1101 zu der Anregungsspule 20 bereitgestellt sind. Die Anregungsspule 20, die Empfangsspulen 22A bis 22C und die Kondensatoren 24A, 24B können beispielsweise auf einer Leiterplatte 1100 bereitgestellt sein.

Die Ausgangssignale Inu, Inv und Inw werden wie dargestellt einer Filter-/Demodulationsanordnung 1102 zugeführt. Die Einrichtung 1102 umfasst eine Anordnung von Eingangswiderständen 1103, wobei jedem Kanal (LN0,

LN1, LN2) zwei Eingangswiderstände zugeordnet sind, deren Funktion derer der Eingangswiderstände 32A, 32B der Fig. 8 entspricht. Der Eingangswiderstandsanordnung 1103 nachgeschaltet ist eine Multiplexer- und Demodulationsanordnung 1104, die von einer Frequenz fdemod gesteuert wird und zunächst die Funktion des Demodulators 33 der Fig. 3 ausführt. Zudem schaltet die Multiplexer- und Demodulatoranordnung 1104 die entsprechenden Eingangskanäle (LNu, LNv, LNw) auf entsprechende Ausgangssignale UP, UN; VP, VN; WP, WN. Dies kann mit einer festen Zuordnung geschehen. Die Zuordnung kann jedoch auch wechseln, um eine dynamische Einrichtungszuordnung (dynamic element matching) zu erreichen.

Eine Kondensatoranordnung 1105 am Ausgang der Multiplexer- und Demodulatoranordnung 1104 ist eine Kapazitätsanordnung 1105 nachgeschaltet, deren Funktion den Kapazitäten 34, 35A, 35B der Fig. 3 bzw. der Kondensatoranordnungen 1000A, 1000B der Fig. 10 entspricht. Für jedes Paar von Ausgangssignalen (UP, UN; VP, VN; WP, WN) der Anordnung 1102 ist dann ein eigener Pfad zur Digitalisierung vorgesehen. Hier erfolgt also im Gegensatz zu der Multiplexerverarbeitung der Figuren 9 und 10 eine parallele Verarbeitung. Diese benötigt im Allgemeinen mehr Chipfläche, ist aber bei gleicher Implementierung der Analog-Digital-Wandler und gleicher Taktung schneller, da alle Signale parallel gewandelt werden. Jeder Pfad umfasst einen Choppermodulator 36A, 36B, 36C, einen zeitkontinuierlichen Sigma-Delta-Analog-Digital-Wandler 37A, 37B, 37C und einen digitalen Chopperdemodulator 38A, 38B, 38C, die in ihrer Funktion den entsprechenden Elementen 36, 37, 38 der Fig. 3 entsprechen. Jeder zeitkontinuierliche Sigma-Delta-Analog-Digital-Wandler 37A, 37B, 37C kann wie der zeitkontinuierliche Sigma-Delta-Analog-Digital-Wandler 37 der Fig. 3 Integratorkondensatoren und, die mit einem Chopper mit dem Rest des Wandlers verbunden sind, wie die Elemente 39, 310A und 310B der Fig. 3, aufweisen. Diese sind in Fig. 11 nicht separat dargestellt. Die Chopperfrequenz fchop kann wie bereits oben erläutert mit der Demodulatorfrequenz fdemod synchronisiert sein.

Zudem ist die Demodulatorfrequenz fdemod mit der Anregungsfrequenz, die der Anregungsspule 20 zugeführt wird, synchronisiert. Auch zwischen den jeweiligen Elementen 36A bis 36C, 37A bis 37C und 38A bis 38C kann bei manchen Ausführungsbeispielen eine dynamische Elementzuordnung (dynamic element matching) stattfinden, so dass die Signale eines Kanals mit verschiedenen Kombinationen von Choppermodulator, zeitkontinuierlichen Sigma-Delta-Analog-Digital-Wandler und Chopperdemodulator verarbeitet werden können. Digitale Ausgangssignale u, v und w können dann weiterverarbeitet werden. Wie für den inkrementellen Analog-Digital-Wandler 95 und dort die Bereichsauswahl 94 erläutert kann für jeden der zeitkontinuierlichen Analog-Digital-Wandler 37A, 37B und 37C ebenfalls eine Bereichsauswahl, hier mit dem Bezugszeichen 1109 bezeichnet, bereitgestellt sein.

Zum Erzeugen des Signals fdemod wird das Signal von dem Oszillator 1101 über einen Phasenkomparator 1108 einer Phasenanpassungseinrichtung 1106 zugeführt, welche dann das Signal fdemod synchronisiert zu dem Ausgangssignal des Oszillators 1101 erzeugt. Zudem kann das Oszillator Signal selbst durch einen Demodulator 1107 demoduliert werden. Ein Ausgangssignal des Demodulators 1107 kann dann zum Bestimmen der Amplitude des Oszillatorsignals dienen. Über die Messung der Amplitude kann wie oben beschrieben die Frequenz fdemod auf Basis von Nulldurchgängen der Schwingung mit der Frequenz fLC durch die Anregungsspule 20 und parasitäre Kapazitäten bestimmt werden.

Die Widerstandsanordnung 1103 und die Kapazitätsanordnung 1105 können wiederum zusammen eine Tiefpassfilterfunktion bilden. Zudem kann die Widerstandsordnung 1103 zum Schutz vor elektrostatischen Entladungen (ESD-Schutz) dienen.

Eine derartige dynamische Elementzuordnung kann während des Betriebs, während einer anfänglichen Kalibrierung oder während eines Hochfahrens der Vorrichtung geschehen.

Neben der Bereitstellung eines Rückkopplungspfades wie dem Rückkopplungspfad 1012 der Fig. 10 zur Reduzierung von Welligkeiten kann dies auch zusätzlich oder alternativ bei einer Vorrichtung, welche mit Multiplexer arbeitet (beispielsweise die Ausführungsformen der Fig. 9 und 10) durch Synchronisierung der Frequenz fADC mit der Chopperfrequenz fchop erreicht werden. Dies ist in Fig. 12 veranschaulicht. Wenn die Frequenz fADC ein ganzzahliges Vielfaches der Chopperfrequenz ist, bedeutet das, dass die Integration des Signals inklusive einer Chopperwelligkeit, der durch eine Kurve 1200 in der Fig. 12 symbolisiert ist, über eine ganzzahlige Anzahl von Perioden der Chopperwelligkeit, in Fig. 12 durch einen Integrationszeitraum T1 veranschaulicht, stattfindet. Hierdurch können die positiven und negativen Beiträge der Welligkeiten im Wesentlichen heraus gemittelt werden. Ist diese Bedingung nicht der Fall, wie dies durch einen Zeitraum T2 in der Fig. 12 veranschaulicht ist, mitteln sich die Welligkeiten nicht heraus.

Die Fig. 14 zeigt ein Flussdiagram zur Veranschaulichung. Das Verfahren kann mit den vorstehend beschriebenen Vorrichtungen und Systemen ausgeführt werden und wird zur Vereinfachung unter Bezugnahme auf die vorstehend beschriebenen Ausführungsbeispiele beschrieben. Die Anwendung des Verfahrens der Fig. 14 ist jedoch nicht auf die vorstehend beschriebenen Ausführungsbeispielen implementiert.

Bei 1401 umfasst das Verfahren ein direktes Demodulieren eines zu wandelnden Eingangssignals ohne variable Verstärkung, insbesondere ein passives Demodulieren mit einem Mischer, der mit einer Demodulationsfrequenz fdemod betrieben wird.

Ein Beispiel ist die Demodulation mittels des Demodulators 33 der Fig. 2, des Demodulators 12 der Fig. 1 oder des Demodulators 92 der Fig. 9. Die Demodulation kann eine Tiefpassfilterung beinhalten, wobei hierzu Eingangswiderstände und eine dem Demodulator nachgeschaltete Kapazitätsanordnung herangezogen werden können, wie oben beschrieben. Die Eingangswiderstände können zugleich zum Schutz vor elektrostatischen Entladungen dienen.

Bei 1402 wird das so demodulierte Signal zumindest in Zeitabschnitten zeitkontinuierlich analog-digital gewandelt, wobei Choppermodulatoren und Chopperdemodulatoren zum Einsatz kommen, wie dies vorstehend beschrieben wurde. "Zumindest in Zeitabschnitten" bedeutet dabei wie bereits erläutert insbesondere, dass es sich um einen einzigen zeitkontinuierlichen Analog-Digital-Wandler wie in Fig. 3, separate zeitkontinuierliche Analog-Digital-Wandler für jeden Kanal wie in Fig. 11 oder auch um gemultiplexte inkrementelle Analog-Digital-Wandler wie in den Fig. 9 und 10 handeln kann. Variationen und Abwandlungen, die vorstehend für die Vorrichtungen beschrieben wurden, sind entsprechender Weise auch auf das Verfahren der Fig. 14 anwendbar. So können die verschiedenen Frequenzen wie die Demodulationsfrequenz, die Anregungsfrequenz, die Chopperfrequenz oder eine Umschaltfrequenz eines Multiplexers fADC wie oben beschrieben synchronisiert sein, es kann eine Rückkopplung zur Verringerung von Welligkeiten wie in Fig. 10 angewendet werden, es kann ein Multiplexen angewendet werden oder es kann eine dynamische Elementzuordnung verwendet werden. Diese Aufzählung ist nicht als abschließend anzusehen, und alle oben beschriebenen Variationen und Ergänzungen sind in entsprechender Form auch auf das Verfahren anwendbar.

Bei den obigen Ausführungen erfolgt zum einen eine Demodulation mittels eines Demodulators bei einer Demodulationsfrequenz fdemod und zum anderen ein Choppen bei einer Chopperfrequenz fchop. Bei im Folgenden diskutierten Ausführungsformen wird ein zeitkontinuierlicher Analog-Digital-Wandler, insbesondere ein Sigma-Delta-Analog-Digital-Wandler, mit inhärenter Chopper- und Demodulationsfunktion verwendet.

Entsprechende Ausführungsbeispiele werden nunmehr unter Bezugnahme auf die Fig. 15 bis 23 diskutiert. Komponenten und Elemente, die bereits in den vorstehend beschriebenen Ausführungsbeispielen verwendet wurden, tragen die gleichen Bezugszeichen und werden nicht nochmals detailliert erläutert.

Die Fig. 15A zeigt ein System mit einer Vorrichtung zur Analog-Digital-Wandlung gemäß einem Ausführungsbeispiel. Wie bereits unter Bezugnahme auf die Fig. 3 beschrieben, empfängt die Vorrichtung zur Analog-Digital-Wandlung der Fig. 15A ein Signal von einer Empfangsspule 30 an Eingangspads 31A, 31B. Im Falle der Fig. 15A sind keine Eingangswiderstände bereitgestellt, und die an den Pads 31A, 31B anliegende Eingangsspannung Vin, wird einem Spannungs-/Stromwandler 80, der im Wesentlichen dem bereits unter Bezugnahme auf die Fig. 8 beschriebenen Spannungs-/Stromwandler 80 entspricht, zugeführt. Im Unterschied zu der für Fig. 8 ist hier allerdings kein Demodulator und kein Chopper vorhanden, sodass die an den Pads 31A, 31B anliegende Eingangsspannung Vin direkt dem bereits diskutierten Strom-/Spannungswandler 80zugeführt wird.

Dem Strom-/Spannungswandler 80 sind die bereits diskutierten Integratorkapazitäten 310A, 310B über den Chopper 39 nachgeschaltet. Kapazitätswerte der Integratorkapazitäten 310A, 310B können im Bereich 5 bis 30pF liegen. Bei dem Ausführungsbeispiel der Fig. 15A können dabei die Kondensatoren 310A, 310 kleinere Kapazitätswerte aufweisen als bei der Fig. 3, beispielsweise um einen Faktor 10 kleinere Kapazitätswerte.

Der Chopper 39 wird mit einer Chopperfrequenz fchop betrieben, die im Gegensatz zu den vorherigen Ausführungsbeispielen der erforderlichen Demodulationsfrequenz fdemod entspricht. Diese Demodulationsfrequenz fdemod ergibt sich wie oben diskutiert aus einer mittleren Frequenz des von der Empfangsspule 30 empfangenen Signals. Hierdurch wird zum einen eine Integration, zusammen mit einem Widerstand des Strom- /Spannungswandlers 80 eine RC-Filterung, ein Choppen und eine Demodulation erreicht.

Der Strom-/Spannungswandler 80 ist in Fig. 15B schematisch dargestellt, wobei die Eingangsspannung Vin an Gate-Anschlüssen von Transistoren 1504, 1505 anliegt und das Ausgangssignal über Stromquellen 1502, 1503, 1507, 1508 erzeugt wird. Der in Fig. 15A dargestellte Widerstand des Strom-/Spannungswandlers 80 entspricht einem Widerstand 1506 der Fig. 15B und kann beispielsweise einen Wert in der Größenordnung von 400 Ω haben, während der Drainstrom der Transistoren 1504, 1505 über 200 $\mu$A liegen kann.

Das so analog integrierte, demodulierte und gechoppte Signal wird von einem Digitizer 1500 in ein Digitalsignal gewandelt. Wie später erläutert werden wird kann dieser Digitizer 1500 einen Komparator umfassen. Das digitalisierte Signal wird dann mit einem Multiplizierer 1501 gemäß der Chopperfrequenz fchop (die hier wiederum der Demodulationsfrequenz fdemod entspricht) alternierend mit +1 und -1 multipliziert, um ein digitales Ausgangssignal digout zu erzeugen. Zudem wird das digitale Ausgangssignal digout über einen Digital-Analog-Wandler 87 rückgekoppelt, wie bereits unter Bezugnahme auf die Fig. 8 erläutert. In Fig. 15A sind zudem schematisch Signalwellenformen zur Veranschaulichung gezeigt. Wie am Ausgang bei digout angedeutet hängt die Amplitude des digitalen Ausgangssignals von der Frequenz, mit dem das System der Fig. 15A und insbesondere der Digitizer 1500 betrieben wird, und von dem Kapazitätswerten Cinteg der Kondensatoren 310A, 310B ab.

Die Fig. 15C zeigt eine Differenzspannung zwischen den Integratorkapazitäten 310A und 310B über der Frequenz und zeigt zudem verschiedene Frequenzwerte, nämlich die Frequenz, mit der der Wandler betrieben wird, die Chopperfrequenz gleich der Demodulationsfrequenz sowie eine Frequenz Gm/2n Cinteg, welche sich aus der Transkonduktanz Gm des Spannungs- /Stromwandlers 80 sowie dem Kapazitätswert Cinteg ergibt. Die Transkonduktanz entspricht dabei dem Kehrwert des Widerstandswertes des Widerstandes 1506 des Spannungs- /Stromwandlers 80.

Mit dem Ausführungsbeispiel der Fig. 15A kann eine inhärente Chopper- und Demodulationsfunktion mit einem

zeitkontinuierlichen Analog-Digital-Wandler erreicht werden, ohne dass am Eingang des Spannungs-/Stromwandlers 80 ein Demodulator und ein Chopper bereitgestellt werden müssen. Dies kann das Rauschen der Anordnung verringern und Strom und Chipfläche sparen sowie die Genauigkeit erhöhen. Zudem können Signalfaltungseffekte und Offsetfehler verringert werden. Die durch den Widerstand 1506 und die Kondensatoren 310A, 310B bewirkte RC-Filterung kann die elektromagnetische Kompatibilität verbessern.

Als Alternative zu dem Spannungs-/Stromwandler 80 kann ein entsprechendes System auch mittels eines Operationsverstärkers aufgebaut werden, d.h. die Signal-Integration ist besser im Spannungsbereich zu betrachten, statt einer Integration eines Stroms auf Kondensatoren. Ein entsprechendes Ausführungsbeispiel zeigt die Fig. 16A. Im Ausführungsbeispiel der Fig. 16A sind verglichen mit dem Ausführungsbeispiel der Fig. 15A der Spannungs-/Stromwandler 80, der Chopper 39 und die Kondensatoren 310A, 310B durch eine Anordnung mit einem Operationsverstärker 1600 ersetzt, dessen Eingänge mit den Pads 31A, 31B über Eingangswiderstände 32A, 32B verbunden sind. Ein Widerstandswert der Widerstände 32A, 32B kann in der Größenordnung von 400 Ω liegen. Statt der Kapazitäten 310A, 310B sind in dem Ausführungsbeispiel der Fig. 16A geschaltete Kapazitäten 1602A, 1602B in Rückkopplungspfaden des Operationsverstärkers 1600 wie dargestellt bereitgestellt, die mit Wechselschaltern 1601A bis 1601D wahlweise mit den Eingängen bzw. Ausgängen des Operationsverstärkers 1600 verschaltet werden können. Die Wechselschalter 1601A bis 1601D werden dabei mit der Chopperfrequenz fchop betrieben, die wiederum wie bei dem Ausführungsbeispiel der Fig. 15A gleich der Demodulationsfrequenz fdemod ist.

Ein Ersatzschaltbild des Operationsverstärkers 1600 ist in Fig. 16B gezeigt, mit Stromquellen 1603, 1604 und 1607 sowie Eingangstransistoren 1605, 1606, an deren Gate-Anschlüssen die Eingangsspannung von den Pads 31A, 31B über die Widerstände 32A, 32B angelegt wird.

Im Übrigen entspricht das Ausführungsbeispiel der Fig. 16A demjenigen der Fig. 15A, wobei der Ausgang des Digital-Analog-Wandlers hier auf die Eingänge des Operationsverstärkers 1600 rückgekoppelt wird.

Ein RC-Filter wird hier durch die Widerstände 32A, 32B und die Kapazitäten 1602A, 1602B gebildet. Auch hier wird durch die Kapazitäten 1602A, 1602B eine Integratorfunktion realisiert. Zudem erfolgen ein Choppen und eine Demodulation, ähnlich wie bereits für die Fig. 15A erläutert.

Auch wenn bei den Fig. 15A und 16A eine inhärente RC-Filterung bereitgestellt wird, kann beispielsweise zum Verbessern der Elektromagnetischen Kompatibilität noch ein zusätzliches RC-Filter bereitgestellt werden, welches kleiner dimensioniert sein kann als bei Vorrichtungen, die keine integrierte RC-Filterung durch Integrationskondensatoren aufweisen.

Das Ausführungsbeispiel der Fig. 16A kann bei höheren Temperaturen Vorteile gegenüber dem Ausführungsbeispiel der Fig. 15A aufweisen.

Die folgende Tabelle zeigt verschiedene Beispiele für Eingangsspannungen, Eingangswiderstände 32A, 32B, Kapazitäten Cint der Kondensatoren 1602A, 1602D, ADC-Frequenzen f ADC und Spannungen am Integrator zur weiteren Veranschaulichung. Wie ersichtlich ist, ist für höhere Eingangsspannungen mit kleineren Eingangswiderständen entsprechend eine höhere Integratorkapazität notwendig, um die zu integrierende Spannung klein genug zu halten.

| Vin [mV] | 4 | 120 | 120 | 120 |
|---|---|---|---|---|
| Rin [kΩ] | 0,4 | 4 | 0,4 | 0,4 |
| Cint [pF] | 10 | 10 | 10 | 20 |
| fADC [MH] | 20 | 20 | 20 | 20 |
| Vinteg [V] | 0,05 | 0,15 | 1,5 | 0,375 |

Das oben unter Bezugnahme auf Fig. 4 für die Fig. 3 erläuterte Verhalten trifft auch auf die Ausführungsbeispiele der Fig. 15A und 16A für die erläuterte inheränte RC-Filterung unter Einbeziehung der jeweiligen Integratorkapazitäten zu.

Wie bereits erläutert ist die Demodulationsfrequenz, die bei den Ausführungsbeispielen der Fig. 15A und 16A gleich der Chopperfrequenz ist, bei manchen Ausführungsbeispielen mit einer mittleren Frequenz eines von der Empfangsspule 30 empfangenen Signals sowie mit einer Frequenz fADC, mit der der Analog-Digital-Wandler betrieben wird und das digitale Signal ausgegeben wird, synchronisiert. Mit der Frequenz fADC werden in den oben beschriebenen Ausführungsbeispielen und auch den noch im Folgenden beschriebenen Ausführungsbeispielen beispielsweise der Digitizer 1500, der Komparator 82, der digitale Integrator 83, der Thermometer/Binär-Codierer 86 und der Digital-Analog-Wandler 87 gesteuert. Beispiele für eine derartige Synchronisierung sind in den Fig. 17A bis 17C dargestellt.

Bei dem Ausführungsbeispiel der Fig. 17A erzeugt ein LC-Oszillator 1701 ein Signal, welches über Pads 1700A, 1700B an die bereits unter Bezugnahme auf die Fig. 2 beschriebene Anregungsspule 20, die mit den ebenfalls unter Bezugnahme auf die Fig. 2 beschriebenen Kondensatoren 24A, 24B gekoppelt ist, ausgegeben wird. Das von dem LC-Oszillator 1701 erzeugte Signal wird zudem an eine Phasenregelschleife (PLL) 1702 ausgegeben, die über einen Oszillator und Teiler 1703 (hier als ADC-Oszillator /Teiler bezeichnet) die Chopperfrequenz fchop gleich fdemod, die Frequenz fADC und die Frequenz fdig erzeugt. fADC kann ebenfalls gleich fchop sein. fADC kann beispielsweise aus fdig durch Frequenzteilung erzeugt werden. Beispielsweise kann fdig 40 MHz und fADC 10MHz betragen. fdig dient also gleichsam als Grundlage für die Erzeugung von fADC. In der Fig. 17A werden also fchop, fADC und fdig auf die Anregungsfrequenz, die der LC-Oszillator 1701 für die Anregungsspule 20 erzeugt, synchronisiert, indem das Ausgangssignal des LC-Oszillators 1701 der Phasenregelschleife 1702 als Referenz zugeführt wird, über welcher wiederum der ADC-Oszillator 1703 gesteuert wird.

In der Fig. 17B ist statt dem LC-Oszillator 1701 ein steuerbarer LC-Oszillator 1704 bereitgestellt, welcher beispielsweise eine veränderbare Kapazität wie dargestellt enthalten kann. Diese Kapazität wird über eine digitale PLL 1705 so geregelt, dass die von dem LC-Oszillator 1704 erzeugte Frequenz auf eine von dem ADC-Oszillator 1703 erzeugte Frequenz, die der digitalen PLL 1705 als Referenzfrequenz zugeführt wird, geregelt wird. Während bei der Fig. 17A also der ADC-Oszillator 1703 in Abhängigkeit von der Frequenz des LC-Oszillators 1701 über die PLL 1702 geregelt wird, wird in der Fig. 17B der umgekehrte Weg beschritten, nämlich dass die Frequenz des LC-Oszillators 1704 über die digitale PLL 1705 auf die Frequenz des ADC-Oszillators 1703 geregelt wird. In beiden Fällen können die Frequenzen fchop, fADC und fdig dann auch noch mittels Frequenzteilern erzeugt werden, die mit dem ADC-Oszillator 1703 verschaltet sind. Die oben erwähnte Referenzfrequenz kann ebenfalls frequenzgeteilt sein, z.B. eine frequenzgeteilte Version von fdig.

Eine Variante der Fig. 17B ist in der Fig. 17C gezeigt. Bei dem Ausführungsbeispiel der Fig. 17C ist ein LC-Oszillator 1706 zur Erzeugung des Anregungssignals für die Anregungsspule 20 bereitgestellt, welcher zwei schaltbare Kapazitäten wie dargestellt aufweist. Diese werden von einer digitalen PLL 1707 mittels eines Sigma-Delta-Datenstroms angesteuert. Ansonsten entspricht die Funktionsweise der Fig. 17C derjenigen der Fig. 17D.

Abwandlungen der Ausführungsbeispiele der Fig. 15A und 16A werden nunmehr unter Bezugnahme auf die Fig. 18 bis 22 erläutert.

Die Fig. 18 zeigt eine Variation des Ausführungsbeispiels der Fig. 15A. In der Fig. 18 sind verglichen mit der Fig. 15A den Kondensatoren 310A, 310B Widerstände 1901A, 1901B vorgeschaltet. Die Widerstände 1901A und 1902B bewirken eine Nullstelle in der Übertragungsfunktion der Vorrichung, die bei manchen Ausführungsbeispielen ein unkontrolliertes Aufschwingen der Analog-Digital-Wandlerschleife, im Falle der Fig. 18 im Wesentlichen einer Sigma-Delta-Schleife, aus analogem Integrator (durch die Integratorkapazitäten 310A, 310B), einem digitalen Integrator 83 und dem Digital-Analog-Wandler 87. Die Phase nach den 2 Integratoren in der Schleife kann -180° sein, was in manchen Fällen ein unkontrolliertes Aufschwingen in der Rückkopplung bedeuten könnte. Die Nullstelle durch die eingefügten Widerstände 1901A, 1901B ist in der Lage, diese Phase zu verkleinern oder in anderen Worten, die Phasenreserve zu vergrößern.

Zudem ist in der Fig. 18 der die Digitizer 1500 der Fig. 15A ähnlich der Fig. 8 durch einen Komparator 82, einen digitalen Integrator 83 und einen Thermometer-/Binärcodierer 86 realisiert. Der Multiplizierer 1501 der Fig. 15A ist hier durch einen ersten Multiplizierer 38 zwischen dem Komparator 82 und dem digitalen Integrator 83 und einem zweiten Multiplizierer 1901 in einem Rückkopplungspfad zu dem bereits diskutierten Digital-Analog-Wandler 87 realisiert.

Ansonsten entspricht die Funktionsweise des Ausführungsbeispiels der Fig. 18 demjenigen der Fig. 15A. Wie bei der Fig. 8 können zusätzlich parallel zu dem digitalen Integrator 83 der Zähler 85 und der Addierer 84 bereitgestellt sein, wie unter Bezugnahme auf die Fig. 8 beschrieben.

Die Fig. 19 zeigt ein weiteres Ausführungsbeispiel, welches das Ausführungsbeispiel der Fig. 18 durch eine Rückkopplung zum Beseitigen von Offset-Ripples (Welligkeiten) 2000 ergänzt. Hier wird ein Signal vor oder nach dem Multiplizierer 38 gefiltert und mittels eines Addierers 2001 zu dem Eingang des Digital-Analog-Wandlers 87 hinzugefügt, um Welligkeiten, die durch das Choppen und dergleichen entstehen, zu beseitigen. Dies kann im Wesentlichen wie bereits unter die Bezugnahme auf Fig. 10 erläutert geschehen. Weitere Implementierungen und weitere Informationen zu derartigen Rückkopplungen zur Beseitigung von Chopperinduzierten Welligkeiten sind auch der deutschen Patentanmeldung DE 10 2020 111 914.3 der Anmelderin zu entnehmen

Im Wesentlichen ist es dabei so, dass durch das Choppen ein Offset, das heißt ein Gleichspannungsversatz, beseitigt wird, aber hierdurch eine Wechselspannungs(AC)-Welligkeit im Ausgangssignal erzeugt wird. Diese wird durch die zusätzliche digitale Offset-Ripple-Rückkopplung 2000 kompensiert.

Die Fig. 20 zeigt eine Modifizierung des Ausführungsbeispiels der Fig. 16A. Zusätzlich zu der Fig. 16A sind hier der Digitizer 1500 und der Multiplizierer 1501 wie bei der Fig. 19 durch den Komparator 82, den Multiplizierer 38, den digitalen Integrator 83, den Thermometer-/Binärcodierer 86 und den Multiplizierer 1901 implementiert. Des Weiteren ist wie in der Fig. 19 die digitale Offset-Ripple-Rückkopplung 2000 mit dem Addierer 2001 implementiert. Schließlich weist das Ausführungsbeispiel der Fig. 20 schaltbare Eingangswiderstände 2101A, 2101B bzw. 2102A, 2102B auf, wobei die Widerstände 2101A, 2101B mittels Schaltern 2100A, 2100B aktiviert und deaktiviert werden können. Die Widerstände 2101A, 2102B können dabei beispielsweise um einen Faktor 10 kleinere Widerstandswerte aufweisen als die Widerstände 2102A, 2102B, sodass bei geschlossenen Schaltern 2100A, 2100B die Widerstände 2101A, 2101B den Gesamteingangswiderstand bestimmen. Beispielsweise können die Widerstände 2101A, 2101B Widerstandswerte

von ca. 400 Ohm aufweisen, und die Widerstände 2102A, 2102B können Widerstandswerte beispielsweise von 4 kΩ aufweisen. Auf diese Weise kann zwischen verschiedenen Eingangssignalbereichen umgeschaltet werden. Die verschiedenen Modifikationen der Fig. 20 verglichen mit der Fig. 16A (Implementierung des Digitizers, digitale Offset-Ripple-Rückkopplung und schaltbare Eingangswiderstände) können dabei unabhängig voneinander implementiert sein, auch wenn sie in der Fig. 20 gemeinsam dargestellt sind.

Die Fig. 21 zeigt eine Variante des Ausführungsbeispiels der Fig. 20. Statt der digitalen Offset-Ripple-Rückkopplung 2000 ist hier eine analoge Offset-Ripple-Rückkopplung 2201 vorgesehen, welche die Eingänge des Operationsverstärkers 1600 zusätzlich in Abhängigkeit von an dem Eingang des Komparators 82 abgegriffenen Signalen beaufschlagt. Zudem ist statt des Digital-Analog-Wandlers 87 ein Digital-Analog-Wandler 2200 bereitgestellt, welcher schaltbare Widerstände aufweist, die auf eine Eingangsspannung oder eine Referenzspannung gelegt werden können. Ein derartiger Digital-Analog-Wandler wird auch bei herkömmlichen Aufbauten zusammen mit Operationsverstärkern statt stromgesteuerten Digital-Analog-Wandlern wie dem Digital-Analog-Wandler 87 verwendet. Auch diese Varianten (analoge Rückkopplung 2201 und Digital-Analog-Wandler 2200) können unabhängig voneinander implementiert sein.

Die Fig. 22 zeigt eine Abwandlung der Fig. 19. Hier wird statt der digitalen Offset-Ripple-Rückkopplung 2000, mit der über den Addierer 2001 der Eingang des Digital-Analog-Wandlers 87 beaufschlagt wird, der Ausgang der digitalen Offset-Ripple-Rückkopplung 2000 über einen separaten Analog-Digital-Wandler 2300 dem Spannungs-/Stromwandler 80 zugeführt. Statt des Multiplizierers 1901 ist dann ein Chopper 2301 am Ausgang des Digital-Analog-Wandlers 87 bereitgestellt. Wie aus den Fig. 19 bis 22 ersichtlich gibt es also verschiedene Möglichkeiten, den Offset-Ripple zu beseitigen.

Ansonsten sind Modifikationen und Abwandlungen, die für die Ausführungsbeispiele der Fig. 1 bis 14 diskutiert wurden, auch auf die Ausführungsbeispiele der Fig. 15 bis 22 anwendbar.

Manche Ausführungsbeispiele werden durch die folgenden Beispiele definiert:

Beispiel 1. Vorrichtung zur Analog-Digital-Wandlung, umfassend:

einen Demodulator zum Demodulieren eines Eingangssignals mit einem Demodulationssignal, welches eine Demodulationsfrequenz aufweist, ohne variable Vorverstärkung, einen dem Demodulator nachgeschalteten Choppermodulator zum Choppen auf Basis eines Choppersignals,
einen dem Choppermodulator nachgeschalteten zumindest in Zeitabschnitten zeitkontinuierlichen arbeitenden Analog-Digital-Wandler, und
einen Chopperdemodulator zum Choppen auf Basis des Choppersignals.

Beispiel 2. Vorrichtung nach Beispiel 1, wobei der Demodulator einen Mischer zum Mischen des Eingangssignals mit dem Demodulationssignal umfasst.

Beispiel 3. Vorrichtung nach Beispiel 1 oder 2, wobei der Demodulator mindestens einen vorgeschalteten Eingangswiderstand und eine nachgeschaltete Kondensatoranordnung aufweist, wobei der mindestens eine Eingangswiderstand und die Kondensatoranordnung einen Tiefpassfilter bilden.

Beispiel 4. Vorrichtung nach einem der Beispiele 1 bis 3, wobei eine Demodulationsfrequenz des Demodulationssignals ein ganzzahliges Vielfaches einer Chopperfrequenz des Choppersignals ist.

Beispiel 5. Vorrichtung nach einem der vorgehenden Beispiele, wobei der Analog-Digital-Wandler Integratorkapazitäten aufweist, die mit dem übrigen Analog-Digital-Wandler über eine Choppervorrichtung, die auf Basis des Choppersignals arbeitet, verbunden sind.

Beispiel 6. Vorrichtung nach einem der vorhergehenden Beispiele, wobei das Eingangssignal dem Demodulator direkt zugeführt wird.

Beispiel 7. Vorrichtung zur Analog-Digital-Wandlung, umfassend:
einen zumindest in Zeitabschnitten zeitkontinuierlichen arbeitenden Analog-Digital-Wandler, welcher aufweist:
mindestens eine Integratorkapazität, die mit dem übrigen Analog-Digital-Wandler in Abhängigkeit von einem Choppersignals verbunden ist, wobei das Choppersignal eine Frequenz aufweist, die gleich einer Demodulationsfrequenz zum Demodulieren eines Eingangssignals der Vorrichtung ist, und einen Chopperdemodulator zum Choppen auf Basis des Choppersignals.

Beispiel 8. Vorrichtung nach Beispiel 7, wobei der Analog-Digital-Wandler einen Spannungs/Stromwandler umfasst, wobei Eingänge des Spannungs/Stromwandlers eingerichtet sind, das Eingangssignal zu empfangen, und wobei

die mindestens eine Integratorkapazität über eine Choppervorrichtung, die auf Basis des Choppersignals arbeitet, mit Ausgängen des Spannungs/Stromwandler verbunden ist.

Beispiel 9. Vorrichtung nach Beispiel 8, wobei die mindestens eine Integratorkapazität über mindestens einen Widerstand mit der Choppervorrichtung verbunden ist.

Beispiel 10. Vorrichtung nach einem der Beispiele 1 bis 9, wobei der Analog-Digital-Wandler mehrere parallele Spannungs/Stromwandler umfasst, wobei Eingänge der mehreren Spannungs/Stromwandlers eingerichtet sind, das Eingangssignal wahlweise zu empfangen.

Beispiel 11. Vorrichtung nach Beispiel 7, wobei der Analog-Digital-Wandler einen Operationsverstärker umfasst, wobei Eingänge des Operationsverstärkers eingerichtet sind, das Eingangssignal zu empfangen, und wobei die mindestens eine Integratorkapazität Wechselschalter, die auf Basis des Choppersignals geschaltet werden, zwischen Eingänge und Ausgänge des Operationsverstärkers geschaltet ist.

Beispiel 12. Vorrichtung nach einem der Beispiele 1 bis 11, wobei der Analog-Digital-Wandler mindestens einen Analog-Digital-Wandler aus der Gruppe umfassend einen zeitkontinuierlichen Sigma-Delta-Analog-Digital-Wandler und einen Analog-Digital-Wandler mit zeitkontinuierlich arbeitendem inkrementellen Wandler aufweist.

Beispiel 13. Vorrichtung nach einem der Beispiele 1 bis 12, wobei der Analog-Digital-Wandler einen Rückkopplungspfad zur Verringerung von Welligkeiten, die durch das Choppen verursacht werden, umfasst.

Beispiel 14. Vorrichtung nach einem der Beispiele 1 bis 13, wobei die Vorrichtung zur Verarbeitung von mehreren Eingangskanälen durch den Analog-Digital-Wandler umfasst ausgelegt ist und einen Multiplexer zur Auswahl eines zu verarbeitenden Eingangskanals umfasst.

Beispiel 15. Vorrichtung nach Beispiel 14 und einem der Beispiele 1 bis 6, wobei der Multiplexer mit dem Demodulator kombiniert ist.

Beispiel 16. Vorrichtung nach Beispiel 14 oder 15, wobei eine Chopperfrequenz des Choppersignals ein ganzzahliges Vielfaches oder gleich einer Wechselfrequenz, mit der der Multiplexer zwischen den Eingangskanälen umschaltet, ist.

Beispiel 17. Verfahren nach einem der Beispiele 1 bis 16, wobei die Vorrichtung zur parallelen Verarbeitung mehrerer Eingangskanäle eingerichtet ist, wobei eine Vielzahl von Analog-Digital-Wandlern umfassend den Analog-Digital-Wandler bereitgestellt ist, wobei die Vorrichtung eine Einrichtung zur dynamischen Elementauswahl zur Verarbeitung der Signale von den Eingangskanälen umfasst.

Beispiel 18. Vorrichtung nach einem der Beispiele 1 bis 17, weiter umfassend eine Einrichtung zur Auswahl eines Eingangsbereichs des Analog-Digital-Wandlers über einen Steuereingang des Analog-Digital-Wandlers.

Beispiel 19. Vorrichtung nach einem der Beispiele 1 bis 18, wobei die Vorrichtung weiter schaltbare Eingangswiderstände zur Auswahl eines Eingangsbereichs des Analog-Digital-Wandlers aufweist.

Beispiel 20. System, umfassend:

einen Sensor, und
eine Vorrichtung zur Analog-Digital-Wandlung nach einem der Beispiele 1 bis 19 zum Verarbeiten eines Signals von dem Sensor.

Beispiel 21. System nach Beispiel 20, wobei der Sensor einen induktiven Sensor mit einer Anregungsspule und mindestens einer Empfangsspule umfasst, von der das Eingangssignal abgreifbar ist, wobei die Demodulationsfrequenz gleich einer Anregungsfrequenz eines Anregungssignals, welches der Anregungsspule zugeführt wird, ist.

Beispiel 22. System nach Beispiel 20 oder 21, wobei eine Taktfrequenz des Analog-Digital-Wandler ein ganzzahliges Vielfaches oder gleich der Frequenz des Demodulationssignals ist.

Beispiel 23. System nach einem der Beispiele 20 bis 22, weiter umfassend eine Phasenregelschleife zum Synchronisieren der Demodulationsfrequenz mit der Anregungsfrequenz und/oder mit der Taktfrequenz des Analog-Digital-Wandlers.

Beispiel 24. Verfahren zur Analog-Digital-Wandlung, umfassend:

direktes Demodulieren eines Eingangssignals ohne variable Vorverstärkung, und
zumindest in Zeitabschnitten zeitkontinuierliches Analog-Digital-Wandeln des demodulierten Eingangssignals mit Choppermodulation und Chopperdemodulation mit einer Chopperfrequenz.

Beispiel 25. Verfahren nach Beispiel 24, wobei das direkte Demodulieren ein Mischen des Eingangssignals mit dem Demodulationssignal umfasst.

Beispiel 26. Verfahren nach Beispiel 24 oder 25, wobei eine Demodulationsfrequenz des Demodulierens ein ganzzahliges Vielfaches einer Chopperfrequenz der Choppermodulation und Chopperdemodulation ist.

Beispiel 27. Verfahren nach einem der Beispiele 24 bis 26, wobei ein Analog-Digital-Wandler Integratorkapazitäten aufweist, wobei das Verfahren weiter umfasst:
Choppen einer Verbindung der Integratorkapazitäten mit dem übrigen Analog-Digital-Wandler.

Beispiel 28. Verfahren zur Analog-Digital-Wandlung, umfassend zumindest in Zeitabschnitten zeitkontinuierliches Analog-Digital-Wandeln eines Eingangssignals, wobei das zumindest in Zeitabschnitten zeitkontinuierliches Analog-Digital-Wandeln ein Betreiben von Integratorkapazitäten basierend auf einem Choppersignal umfasst, wobei das Choppersignal eine Chopperfrequenz aufweist, die gleich einer Demodulationsfrequenz zum Demodulieren eines zu wandelnden Eingangssignals ist.

Beispiel 29. Verfahren nach einem der Beispiele 24 bis 28, wobei das Verfahren zur Verarbeitung von mehreren Eingangskanälen ein Multiplexen zur Auswahl eines zu verarbeitenden Eingangskanals umfasst, wobei die Chopperfrequenz ein ganzzahliges Vielfaches einer Wechselfrequenz, mit der das Multiplexen zwischen den Eingangskanälen umschaltet, ist.

Beispiel 30. Verfahren nach einem der Beispiele 24 bis 29, wobei das Verfahren zur Verarbeitung von mehreren Eingangskanälen ein Multiplexen zur Auswahl eines zu verarbeitenden Eingangskanals umfasst.

Obgleich in dieser Beschreibung spezifische

Ausführungsbeispiele illustriert und beschrieben wurden, werden Personen mit üblichem Fachwissen erkennen, dass eine Vielzahl von alternativen und/oder äquivalenten Implementierung als Substitution für die spezifischen Ausführungsbeispiele, die in dieser Beschreibung gezeigt und beschrieben sind, ohne von dem Umfang der gezeigten Erfindung abzuweichen, gewählt werden können. Es ist die Intention, dass diese Anmeldung alle Adaptionen oder Variationen der spezifischen Ausführungsbeispiele, die hier diskutiert werden, abdeckt. Daher ist es beabsichtigt, dass diese Erfindung nur durch die Ansprüche und die Äquivalente der Ansprüche beschränkt ist.

## Patentansprüche

**1.** Vorrichtung zur Analog-Digital-Wandlung, umfassend:
einen zumindest in Zeitabschnitten zeitkontinuierlichen arbeitenden Analog-Digital-Wandler, welcher aufweist:
mindestens eine Integratorkapazität (310A, 310B; 1602A, 1602B), die mit dem übrigen Analog-Digital-Wandler (14; 37; 37A-37D) in Abhängigkeit von einem Choppersignals (fchop) verbunden ist, wobei das Choppersignal (fchop) eine Frequenz aufweist, die gleich einer Demodulationsfrequenz zum Demodulieren eines Eingangssignals der Vorrichtung ist, und einen Chopperdemodulator (1501; 38, 1901; 2301) zum Choppen auf Basis des Choppersignals (fchop).

**2.** Vorrichtung nach Anspruch 1, wobei der Analog-Digital-Wandler einen Spannungs/Stromwandler (80) umfasst, wobei Eingänge des Spannungs/Stromwandlers (80) eingerichtet sind, das Eingangssignal zu empfangen, und wobei die mindestens eine Integratorkapazität (310A, 310B; 1602A, 1602B) über eine Choppervorrichtung (39), die auf Basis des Choppersignals (fchop) arbeitet, mit Ausgängen des Spannungs/Stromwandler (80) verbunden ist.

3. Vorrichtung nach Anspruch 2, wobei die mindestens eine Integratorkapazität (310A, 310B; 1602A, 1602B) über mindestens einen Widerstand (1901A, 1901B) mit der Choppervorrichtung (39) verbunden ist.

4. Vorrichtung nach einem der Ansprüche 1 bis 3, wobei der Analog-Digital-Wandler mehrere parallele Spannungs/Stromwandler (80) umfasst, wobei Eingänge der mehreren Spannungs/Stromwandlers (80) eingerichtet sind, das Eingangssignal wahlweise zu empfangen.

5. Vorrichtung nach Anspruch 1, wobei der Analog-Digital-Wandler einen Operationsverstärker (1600) umfasst, wobei Eingänge des Operationsverstärkers (1600) eingerichtet sind, das Eingangssignal zu empfangen, und wobei die mindestens eine Integratorkapazität (310A, 310B; 1602A, 1602B) Wechselschalter (1601A-1601D), die auf Basis des Choppersignals (fchop) geschaltet werden, zwischen Eingänge und Ausgänge des Operationsverstärkers (1600) geschaltet ist.

6. Vorrichtung nach einem der Ansprüche 1 bis 5, wobei der Analog-Digital-Wandler (14; 37; 37A-37D) einen Rückkopplungspfad (1012; 2000; 2201) zur Verringerung von Welligkeiten, die durch das Choppen verursacht werden, umfasst.

7. Vorrichtung nach einem der Ansprüche 1 bis 6, wobei die Vorrichtung zur Verarbeitung von mehreren Eingangskanälen durch den Analog-Digital-Wandler (14; 37; 37A-37D) umfasst ausgelegt ist und einen Multiplexer (90; 1001) zur Auswahl eines zu verarbeitenden Eingangskanals umfasst.

8. Vorrichtung nach Anspruch 7, wobei eine Chopperfrequenz (fchop) des Choppersignals (fchop) ein ganzzahliges Vielfaches oder gleich einer Wechselfrequenz (fADC), mit der der Multiplexer (90; 1001) zwischen den Eingangskanälen umschaltet, ist.

9. Vorrichtung nach einem der Ansprüche 1 bis 8, wobei die Vorrichtung zur parallelen Verarbeitung mehrerer Eingangskanäle eingerichtet ist, wobei eine Vielzahl von Analog-Digital-Wandlern (14; 37; 37A-37D) umfassend den Analog-Digital-Wandler (14; 37; 37A-37D) bereitgestellt ist, wobei die Vorrichtung eine Einrichtung (94; 1103) zur dynamischen Elementauswahl zur Verarbeitung der Signale von den Eingangskanälen umfasst.

10. Vorrichtung nach einem der Ansprüche 1 bis 9, weiter umfassend eine Einrichtung (94; 1103) zur Auswahl eines Eingangsbereichs des Analog-Digital-Wandlers (14; 37; 37A-37D) über einen Steuereingang des Analog-Digital-Wandlers (14; 37; 37A-37D).

11. Vorrichtung nach einem der Ansprüche 1 bis 10, wobei die Vorrichtung weiter schaltbare Eingangswiderstände (2101A, 2101B, 2102A, 2102B) zur Auswahl eines Eingangsbereichs des Analog-Digital-Wandlers (14; 37; 37A-37D) aufweist.

12. System, umfassend:

einen Sensor, und
eine Vorrichtung zur Analog-Digital-Wandlung nach einem der Ansprüche 1 bis 11 zum Verarbeiten eines Signals von dem Sensor,
wobei der Sensor einen induktiven Sensor mit einer Anregungsspule (20) und mindestens einer Empfangsspule (22A-22C) umfasst, von der das Eingangssignal abgreifbar ist, wobei die Demodulationsfrequenz gleich einer Anregungsfrequenz eines Anregungssignals, welches der Anregungsspule (20) zugeführt wird, ist.

13. System nach Anspruch 12, wobei eine Taktfrequenz des Analog-Digital-Wandler (14; 37; 37A-37D) ein ganzzahliges Vielfaches oder gleich der Frequenz des Demodulationssignals (fdemod) ist.

14. System nach Anspruch 12 oder 13, weiter umfassend eine Phasenregelschleife (1702, 1705, 1707) zum Synchronisieren der Demodulationsfrequenz mit der Anregungsfrequenz und/oder mit der Taktfrequenz des Analog-Digital-Wandlers (14; 37; 37A-37D) .

15. Verfahren zur Analog-Digital-Wandlung, umfassend zumindest in Zeitabschnitten zeitkontinuierliches Analog-Digital-Wandeln eines Eingangssignals, wobei das zumindest in Zeitabschnitten zeitkontinuierliches Analog-Digital-Wandeln ein Betreiben von Integratorkapazitäten basierend auf einem Choppersignal umfasst, wobei das Choppersignal (fchop) eine Chopperfrequenz aufweist, die gleich einer Demodulationsfrequenz zum Demodulieren eines

zu wandelnden Eingangssignals ist.

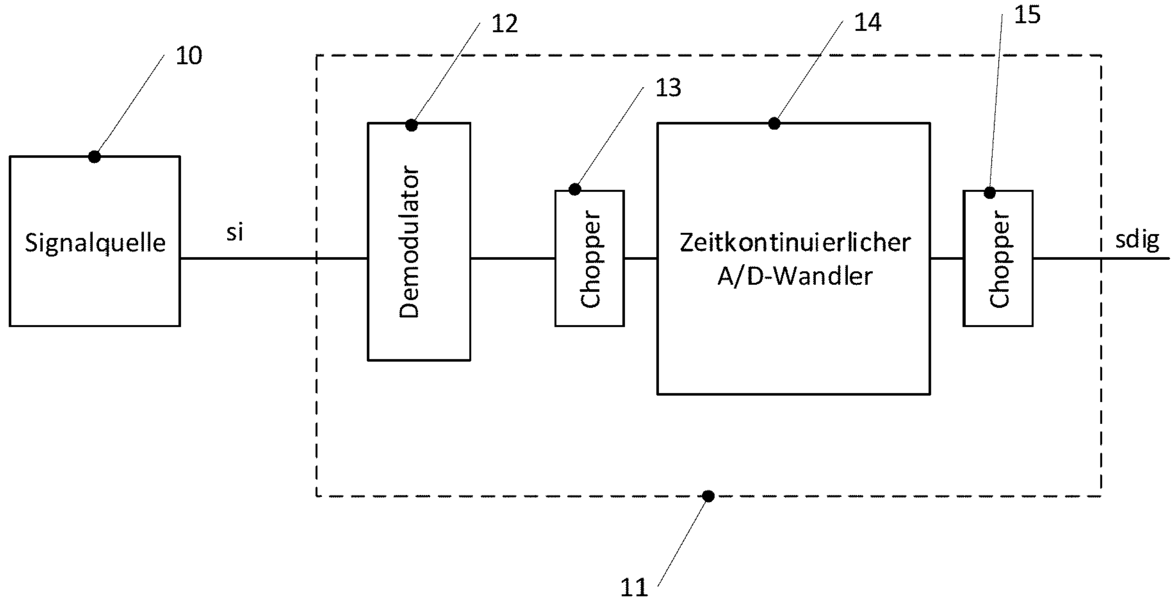
10
12
13
14
15
Signalquelle
si
Demodulator
Chopper
Zeitkontinuierlicher A/D-Wandler
Chopper
sdig
11

Fig. 1

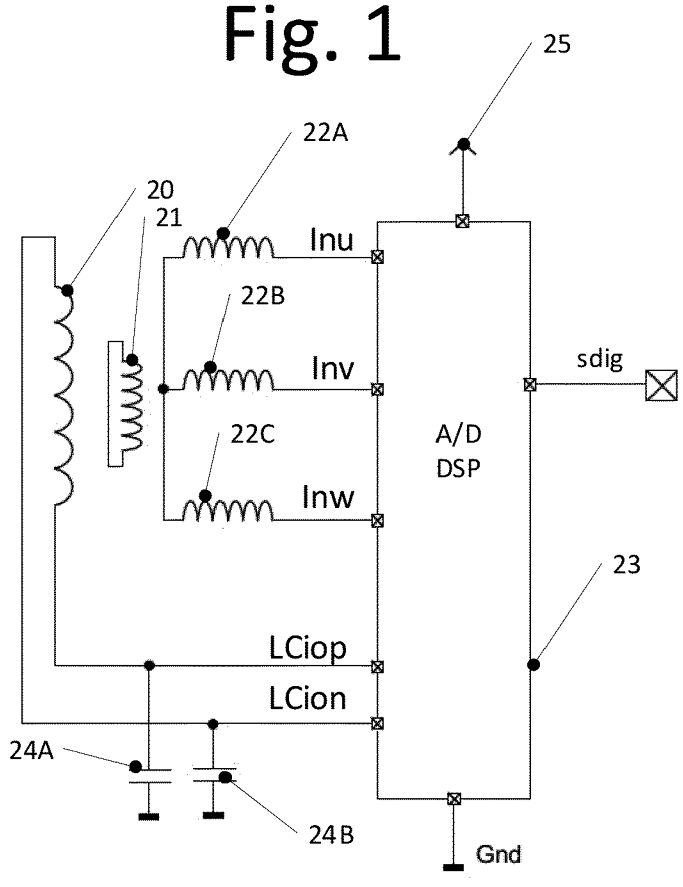
25
22A
20
21
Inu
22B
Inv
22C
Inw
sdig
A/D
DSP
23
LCiop
LCion
24A
24B
Gnd

Fig. 2

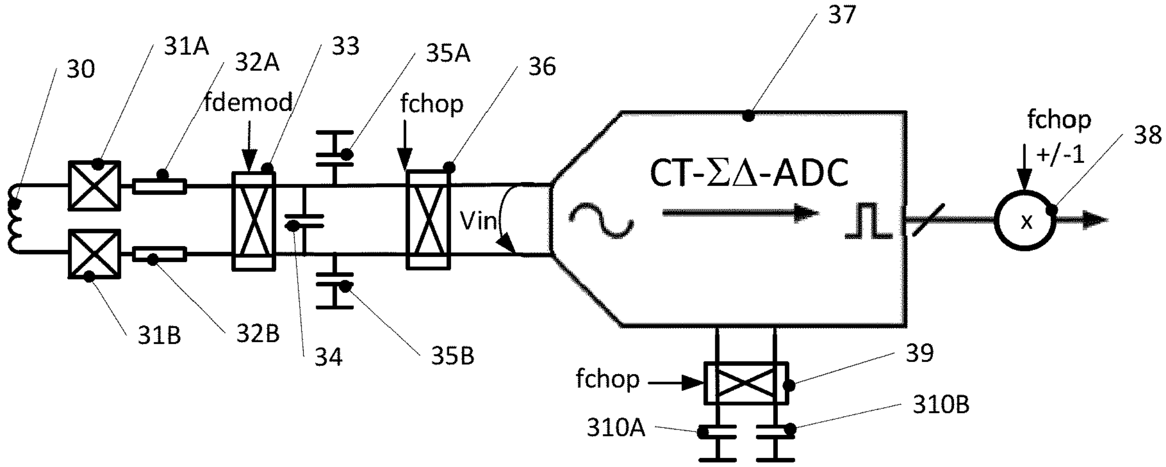
30
31A
32A
fdemod
33
35A
fchop
36
37
CT-ΣΔ-ADC
Vin
fchop
+/-1
x
38
31B
32B
34
35B
fchop
39
310A
310B

Fig. 3

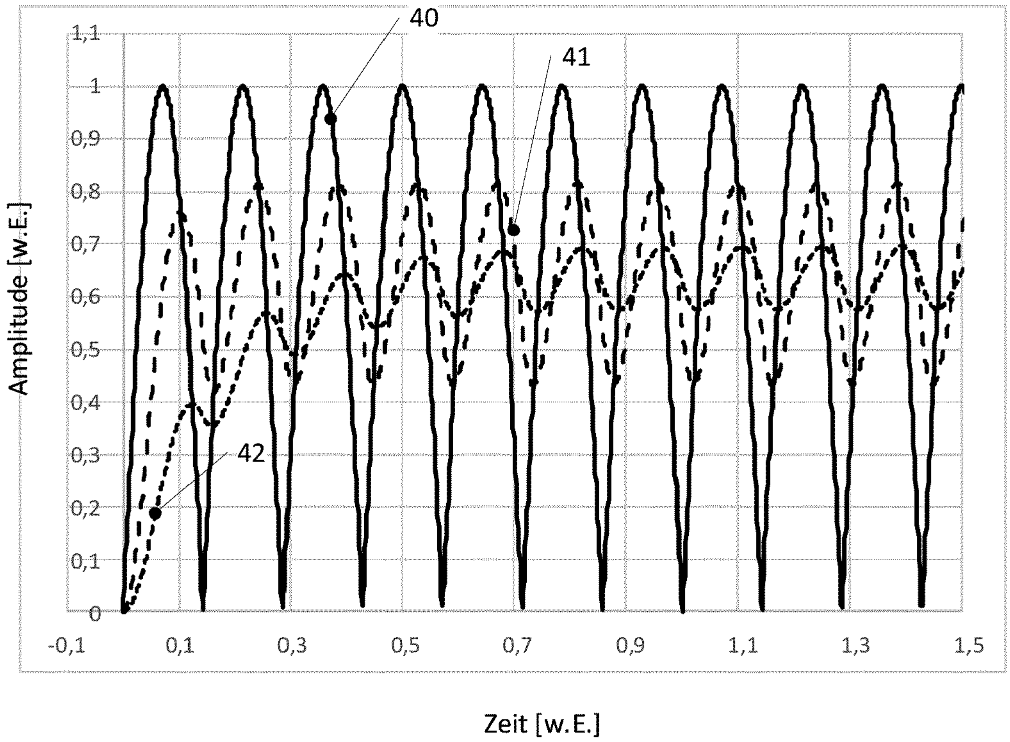
40
41
42
Amplitude [w.E.]
Zeit [w.E.]
1,1
1
0,9
0,8
0,7
0,6
0,5
0,4
0,3
0,2
0,1
0
-0,1
0,1
0,3
0,5
0,7
0,9
1,1
1,3
1,5

Fig. 4

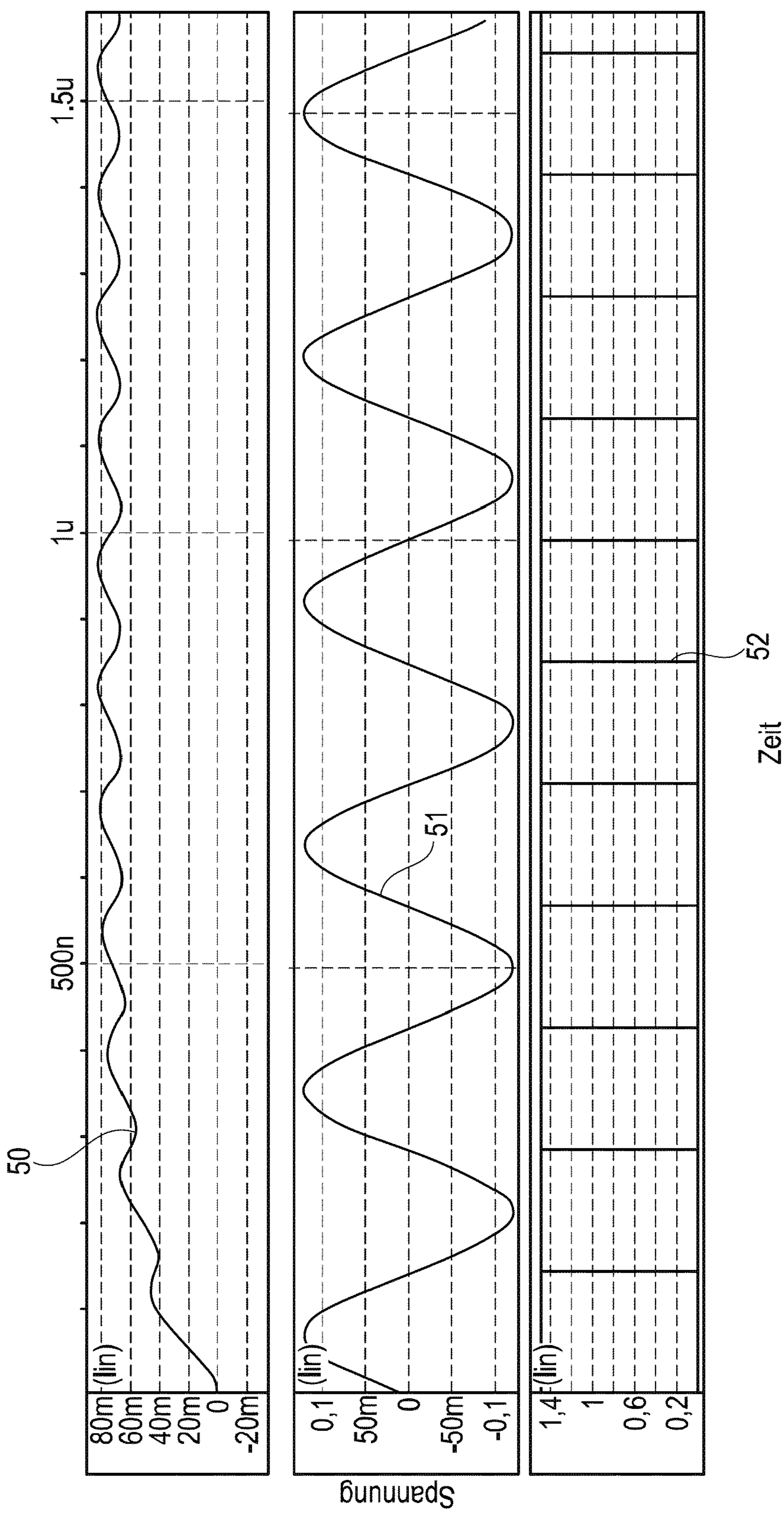
50
51
52
500n
1u
1.5u
80m
60m
40m
20m
0
-20m
(lin)
0,1
50m
0
-50m
-0,1
(lin)
1,4
1
0,6
0,2
(lin)
Spannung
Zeit

Fig. 5

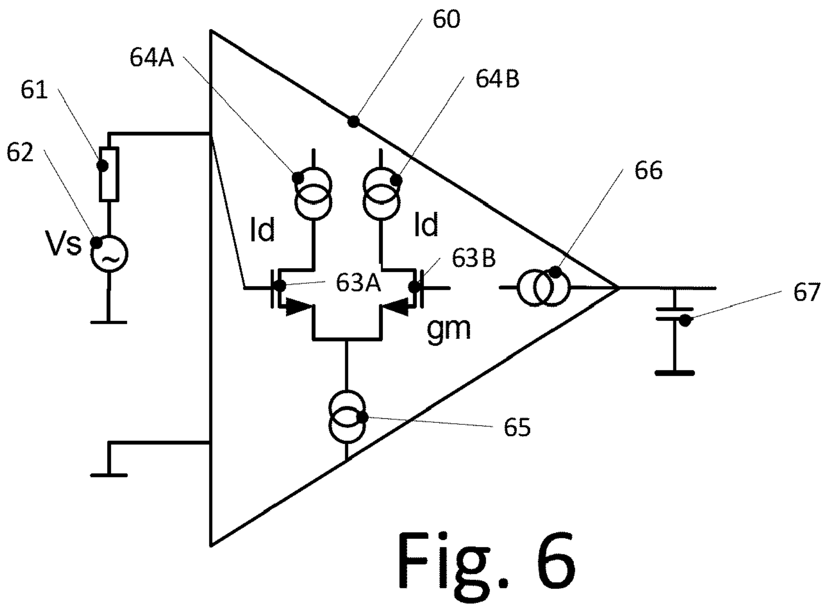


Fig. 6

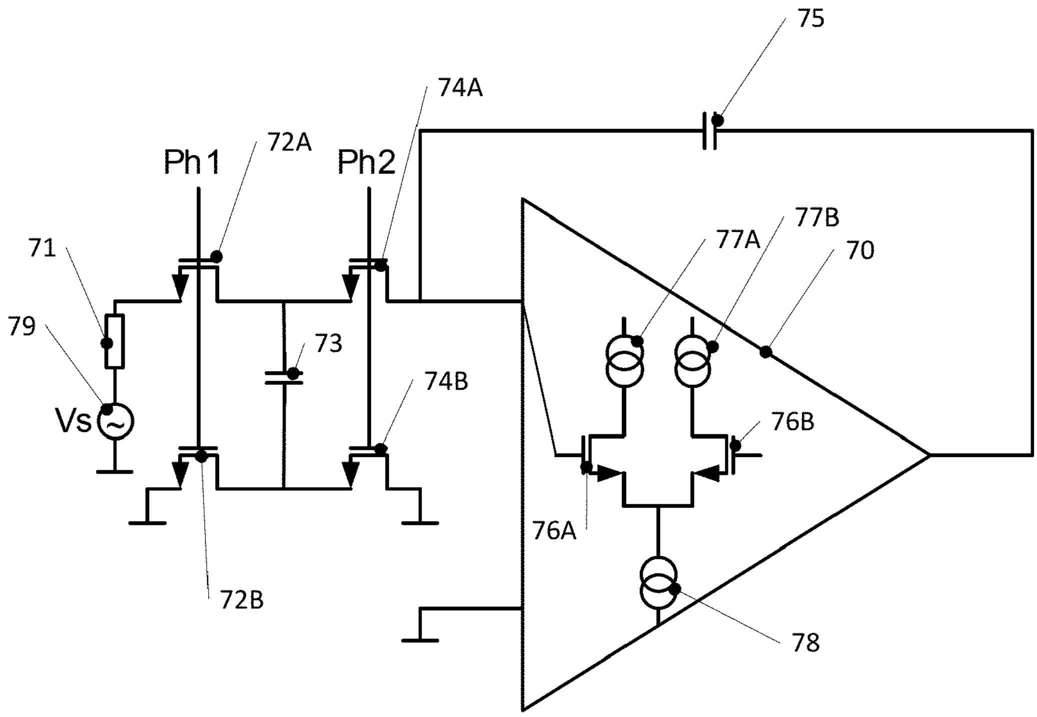


Fig. 7

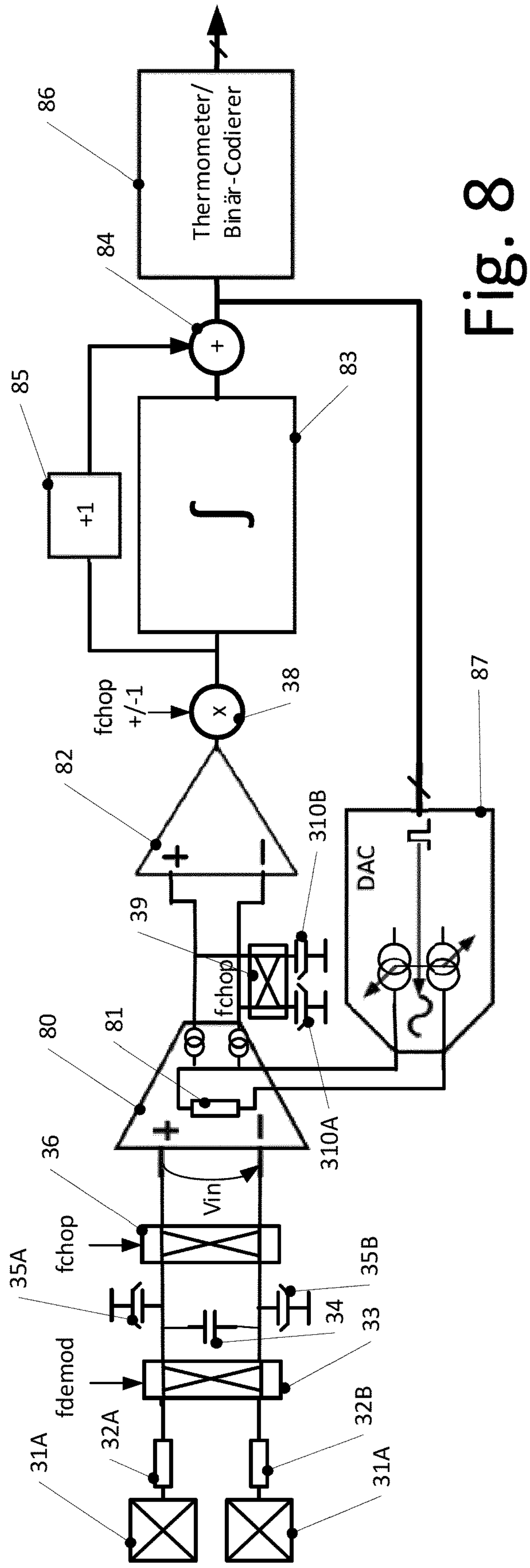
86
Thermometer/
Binär-Codierer
84
+
85
+1
83
∫
fchop
+/-1
x
38
82
+
-
87
DAC
310B
39
fchop
80
81
+
-
310A
36
Vin
fchop
35A
35B
34
33
fdemod
32A
32B
31A
31A

Fig. 8

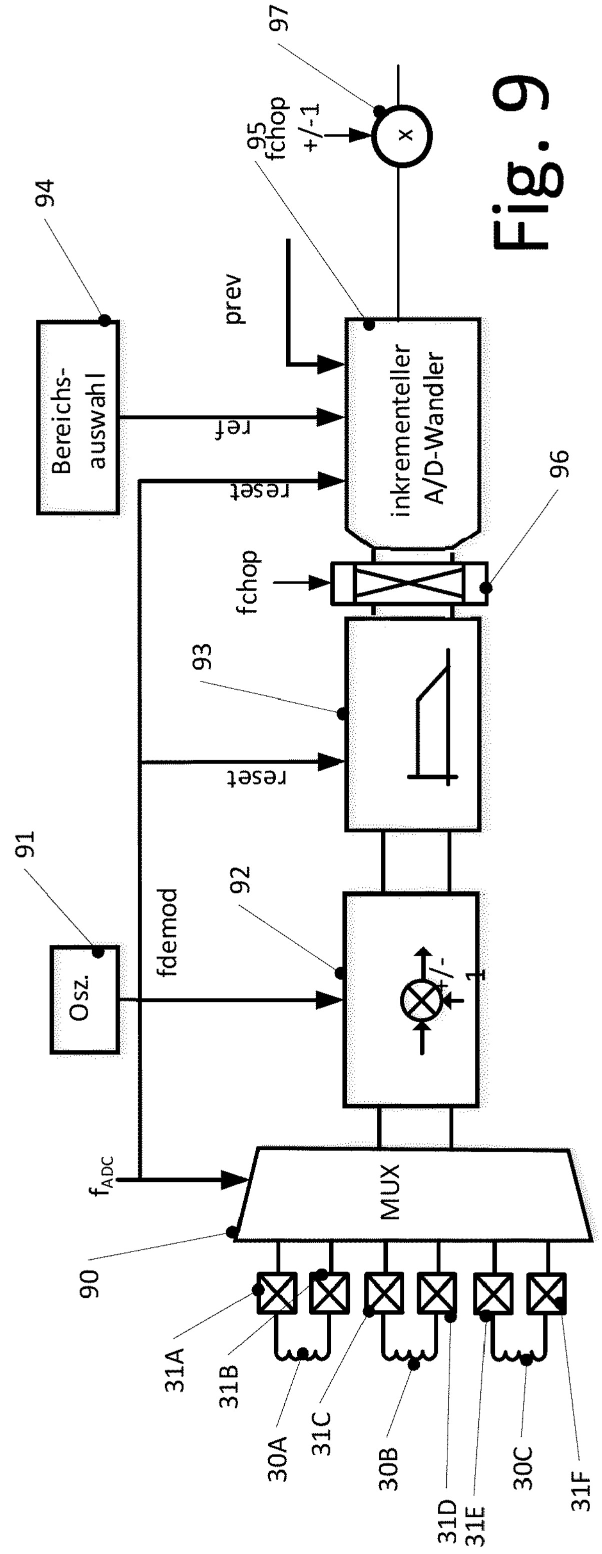
97
95
fchop
+/-1
x
94
Bereichs-
auswahl
prev
ref
reset
inkrementeller
A/D-Wandler
96
fchop
93
reset
91
Osz.
fdemod
92
+/-
1
$f_{ADC}$
MUX
90
31A
31B
30A
31C
30B
31D
31E
30C
31F

Fig. 9

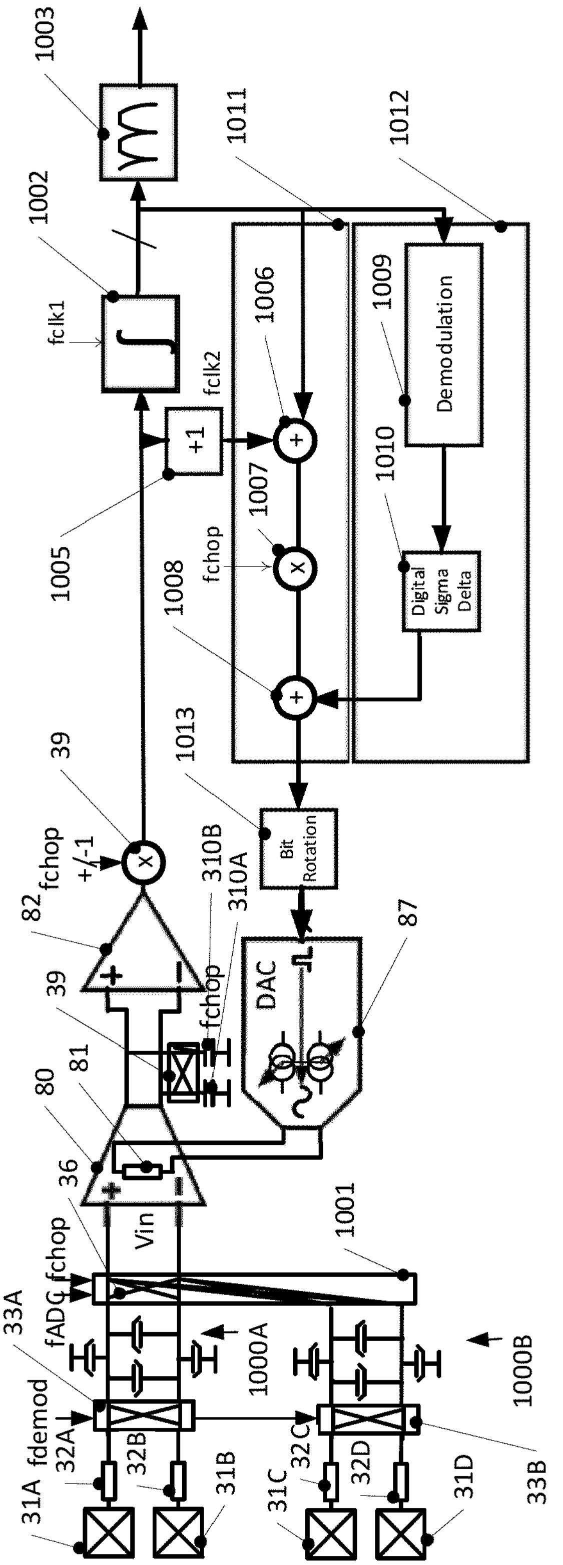
1003
1002
1011
1012
fclk1
fclk2
1006
1009
Demodulation
+1
1005
1007
fchop
1010
1008
Digital Sigma Delta
1013
39
fchop
+/-1
Bit Rotation
82
310B
310A
87
DAC
39
fchop
80
81
36
Vin
1001
33A
fADC fchop
1000A
1000B
fdemod
32A
32B
32C
32D
31A
31B
31C
31D
33B

Fig. 10

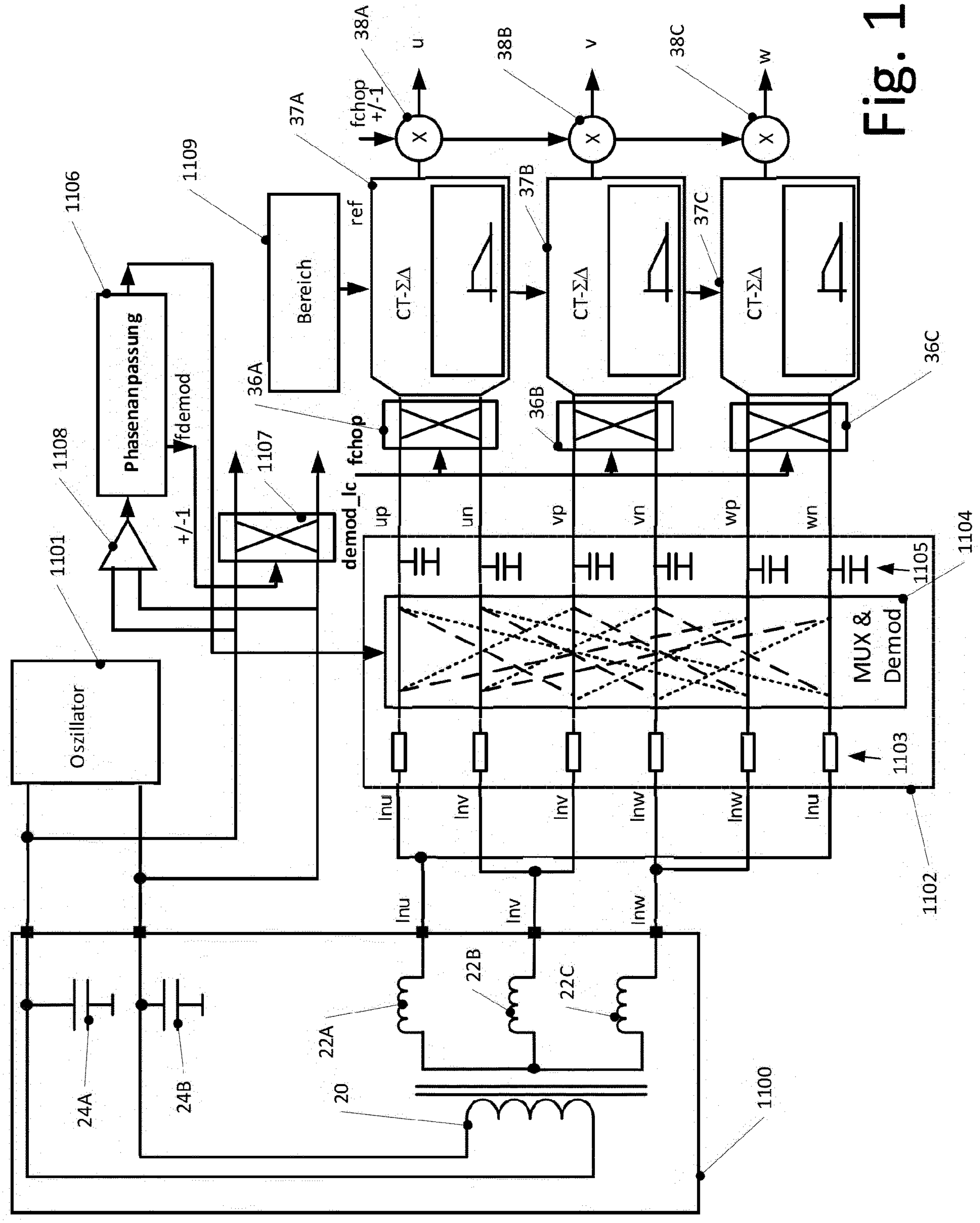
Oszillator
1101
Phasenanpassung
1106
1108
fdemod
+/-1
1107
1109
Bereich
ref
demod_lc
fchop
37A
37B
37C
CT-ΣΔ
36A
36B
36C
fchop
+/-1
38A
38B
38C
u
v
w
up
un
vp
vn
wp
wn
1104
1105
MUX &
Demod
1103
lnu
lnv
lnw
1102
22A
22B
22C
24A
24B
20
1100

Fig. 11

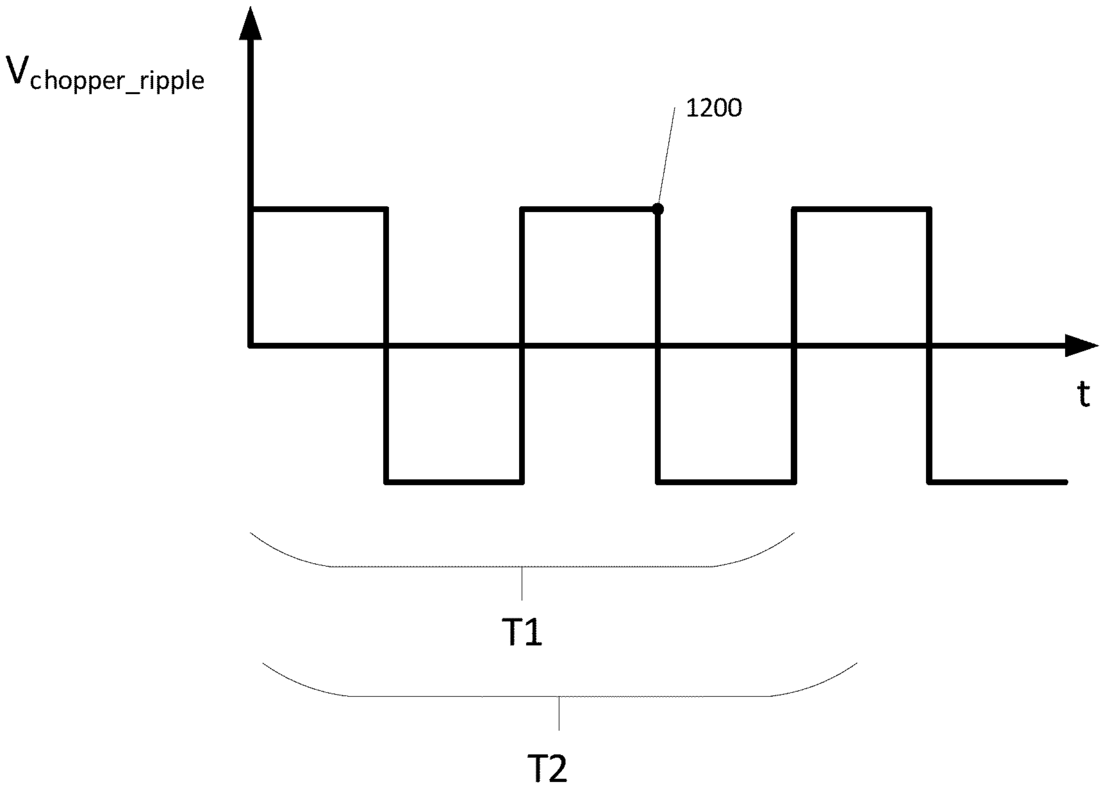


Fig. 12

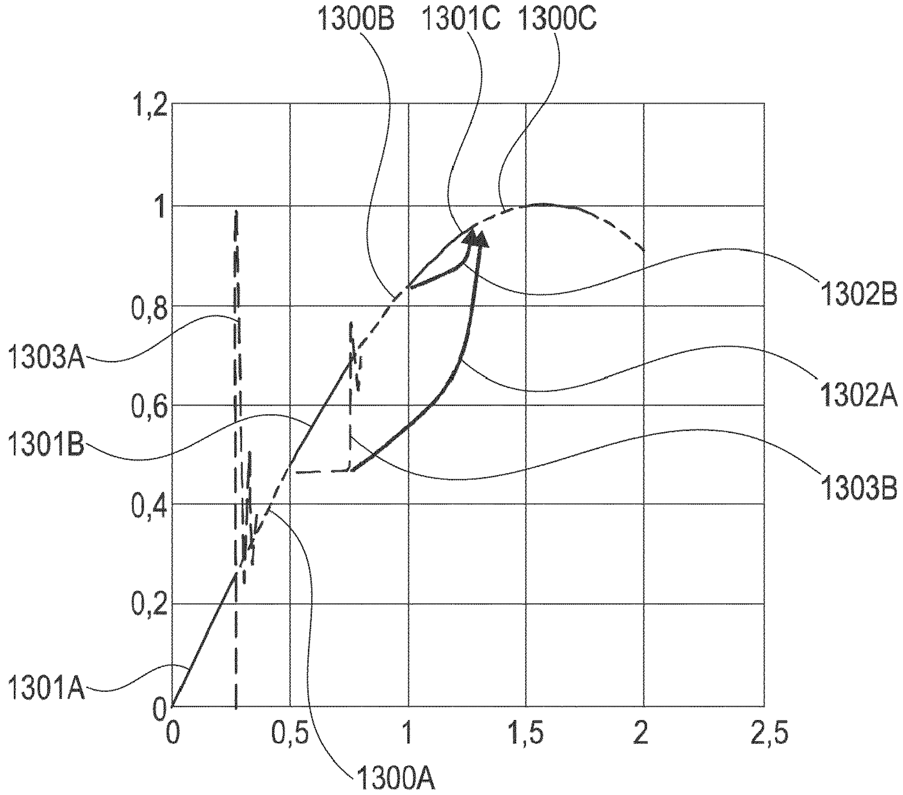
1300B
1301C
1300C
1,2
1
0,8
0,6
0,4
0,2
0
0
0,5
1
1,5
2
2,5
1303A
1301B
1301A
1300A
1302B
1302A
1303B

Fig. 13

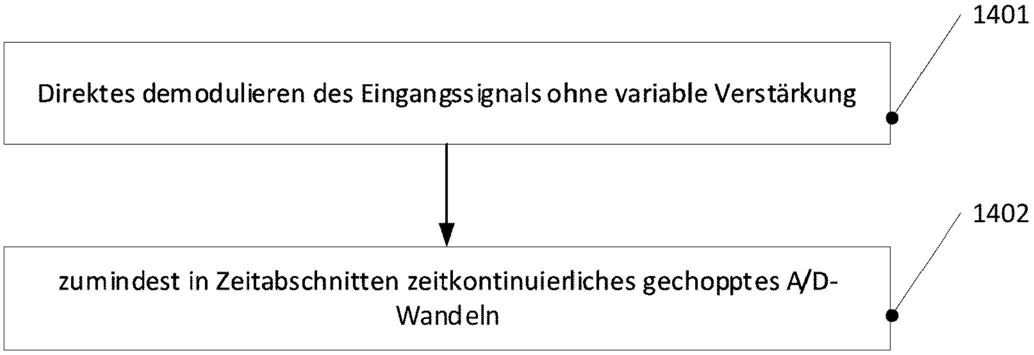
1401
Direktes demodulieren des Eingangssignals ohne variable Verstärkung
1402
zumindest in Zeitabschnitten zeitkontinuierliches gechopptes A/D-Wandeln

Fig. 14

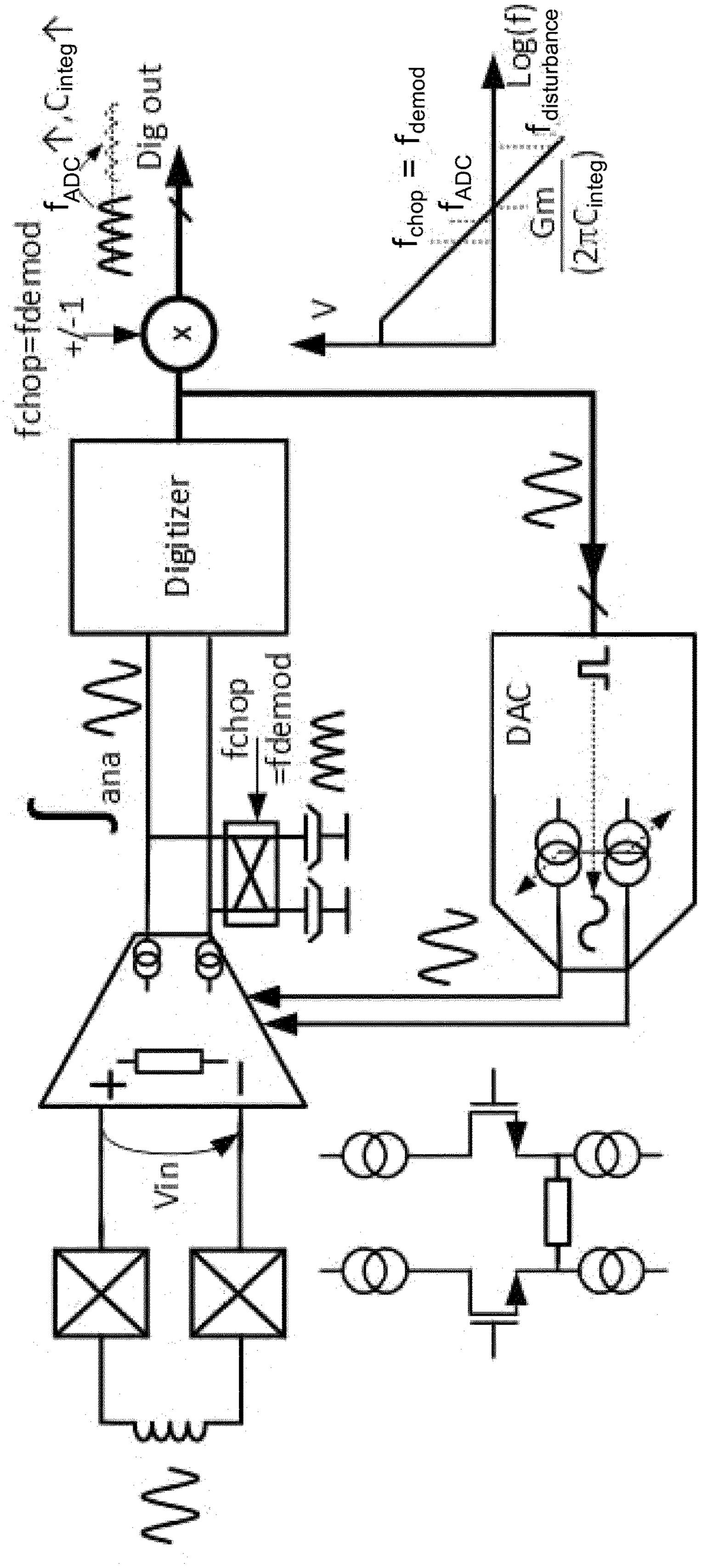
fchop=fdemod
+/-1
$f_{ADC}$ ↑, $C_{integ}$ ↑
Dig out
x
Digitizer
$\int_{ana}$
fchop =fdemod
DAC
Vin
+
-
V
Log(f)
$f_{chop}$ = $f_{demod}$
$f_{ADC}$
$f_{disturbance}$
$\frac{Gm}{(2\pi C_{integ})}$

Fig. 15A

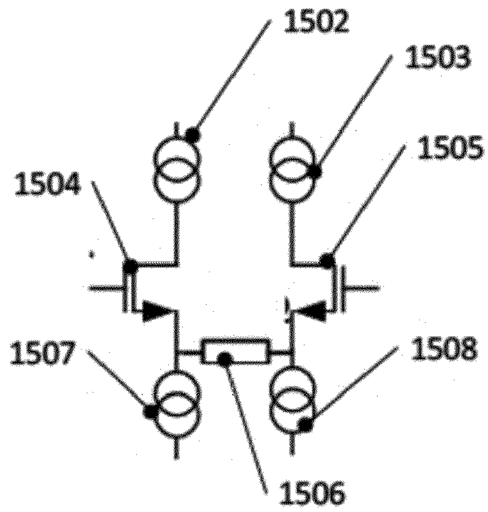


Fig. 15B

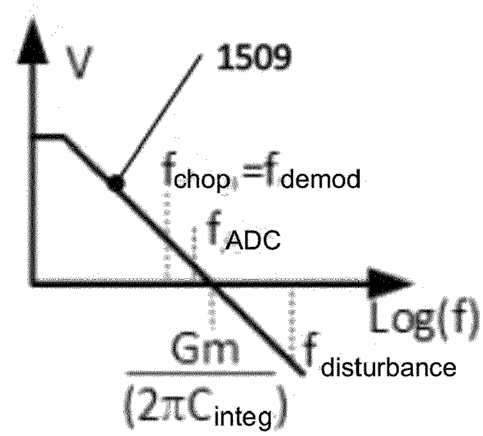


Fig. 15C

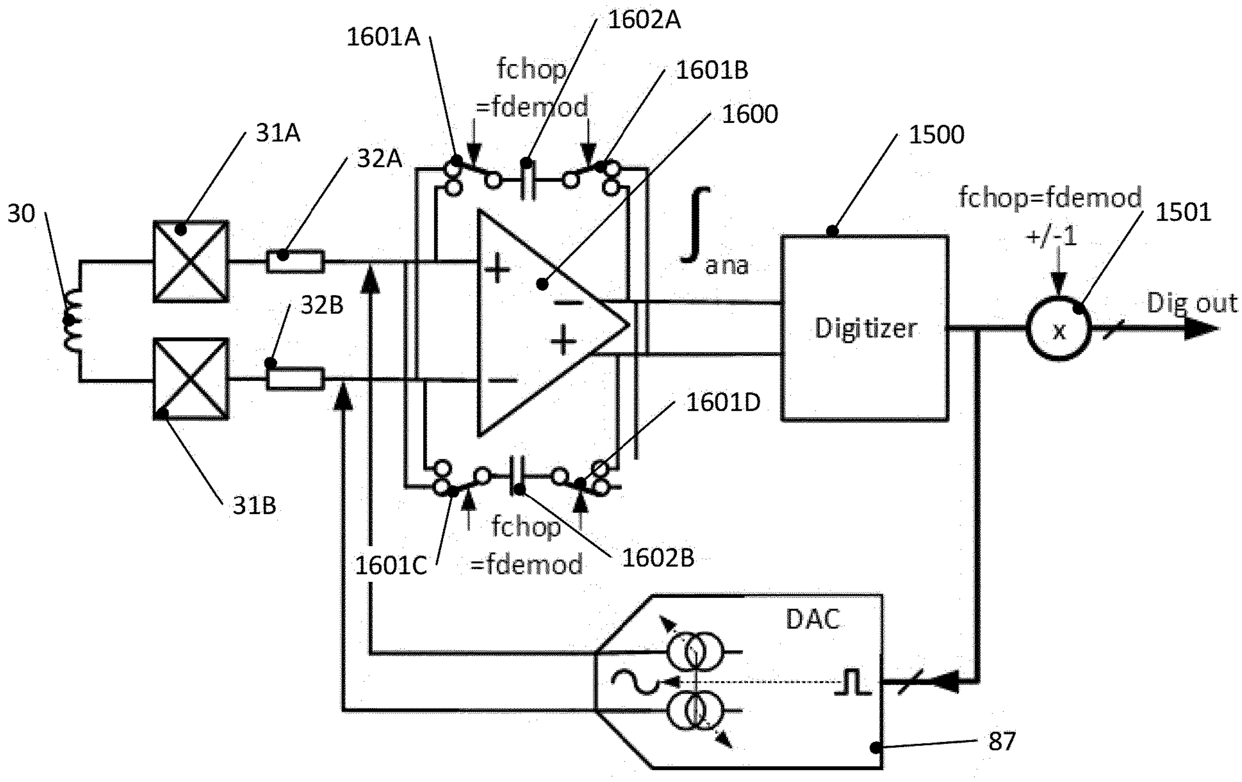


Fig. 16A

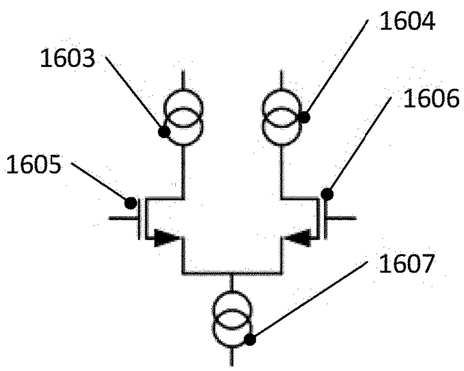


Fig. 16B

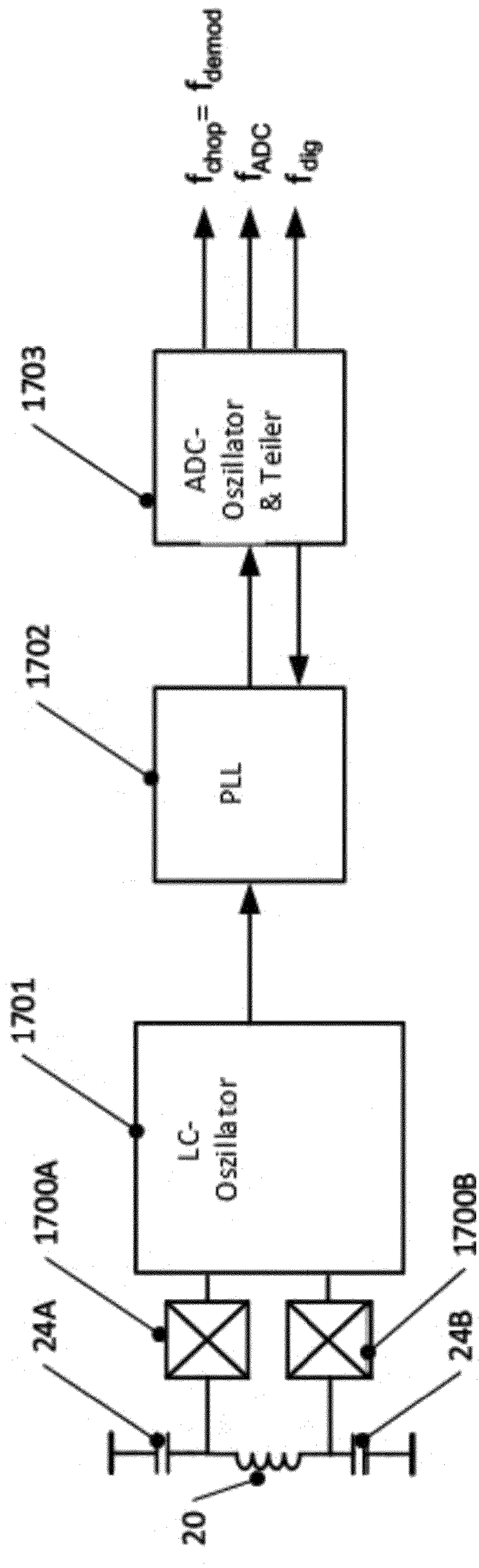

$f_{chop} = f_{demod}$
$f_{ADC}$
$f_{dig}$
1703
ADC-
Oszillator
& Teiler
1702
PLL
1701
LC-
Oszillator
1700A
1700B
24A
24B
20


Fig. 17A

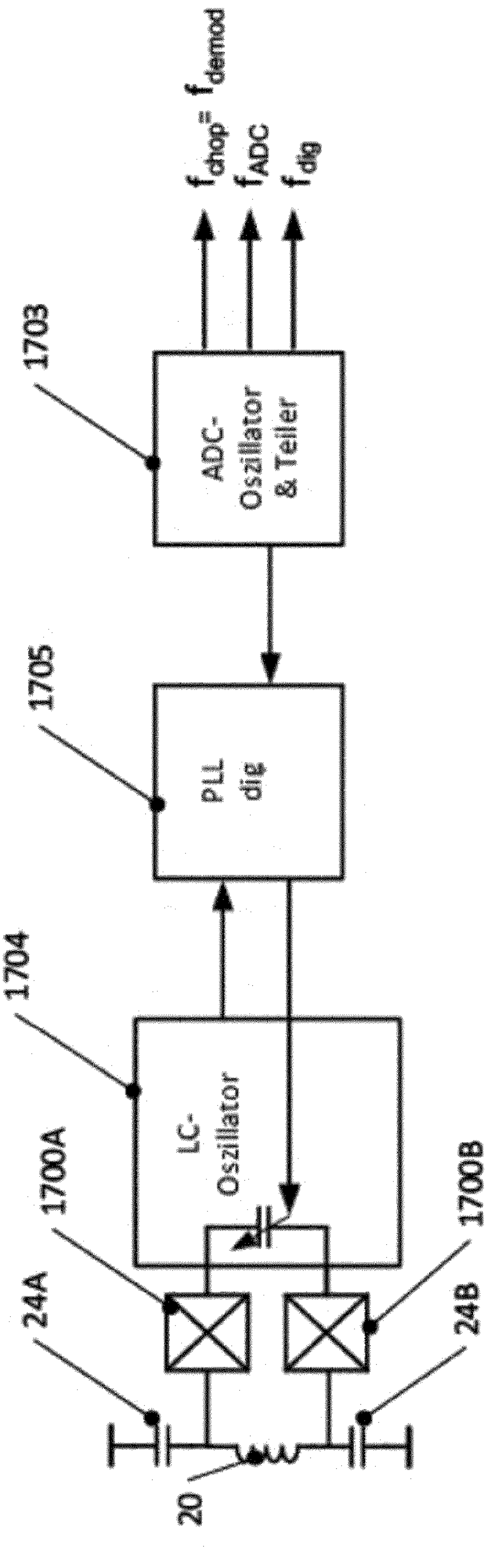
1703
ADC-
Oszillator
& Teiler
$f_{chop} = f_{demod}$
$f_{ADC}$
$f_{dig}$
1705
PLL
dig
1704
LC-
Oszillator
1700A
1700B
24A
24B
20

Fig. 17B

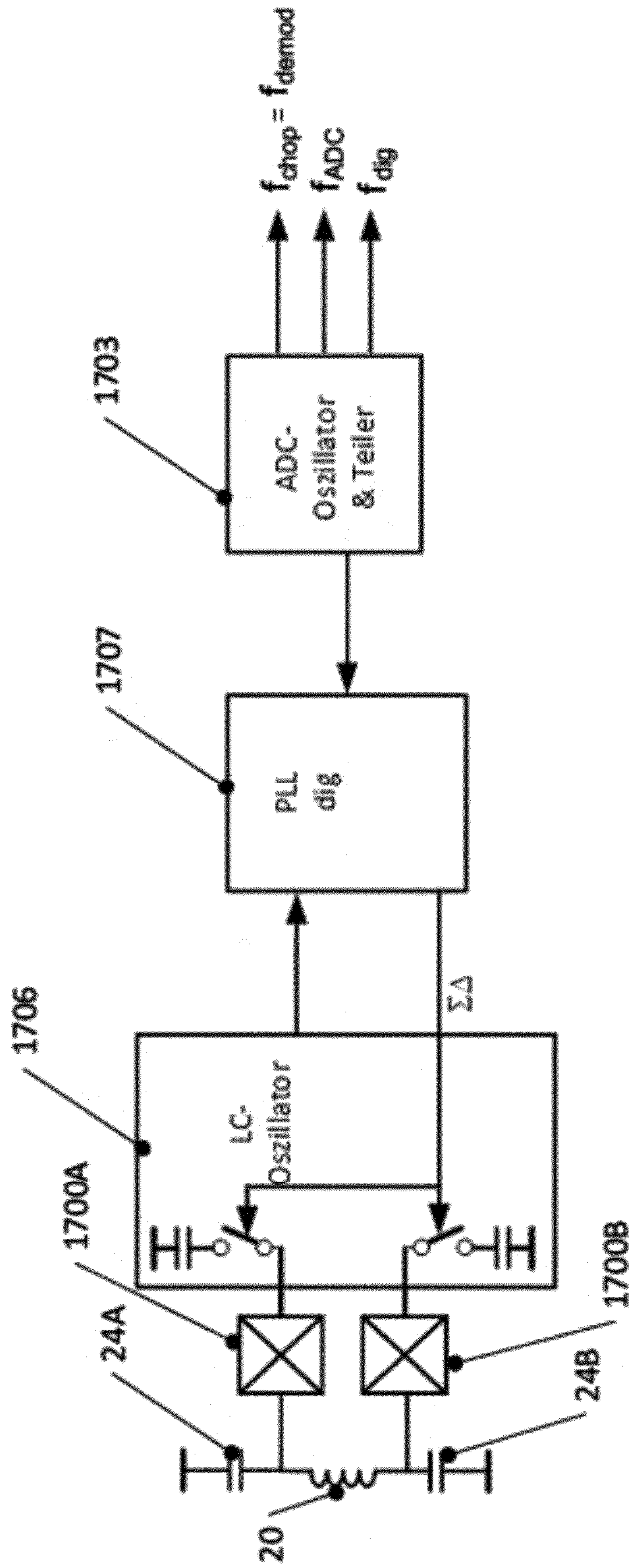

1703
ADC-
Oszillator
& Teiler
$f_{chop} = f_{demod}$
$f_{ADC}$
$f_{dig}$
1707
PLL
dig
1706
LC-
Oszillator
ΣΔ
1700A
1700B
24A
24B
20


Fig. 17C

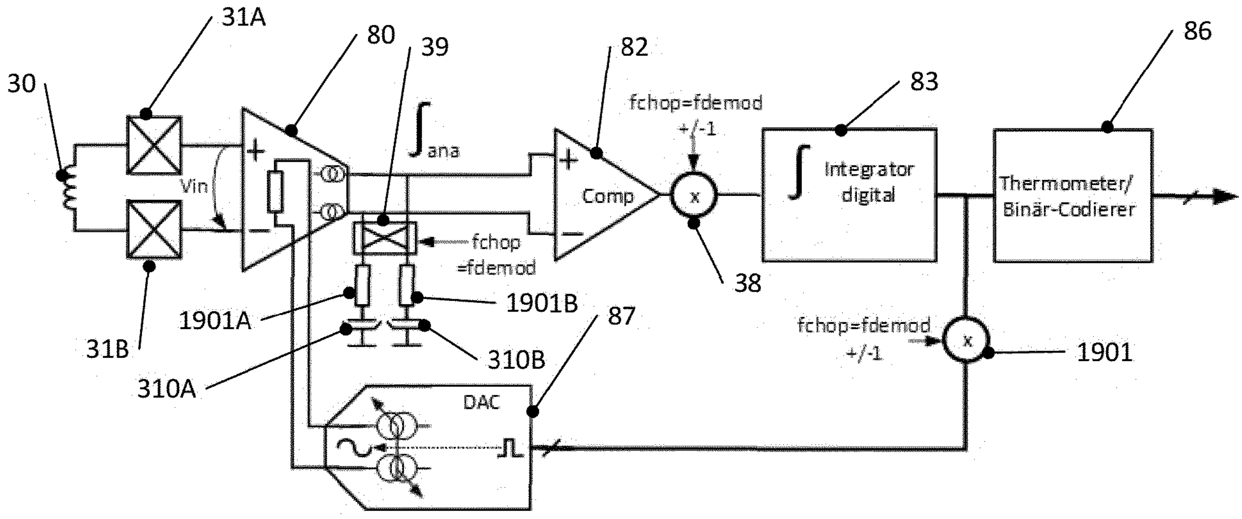
30
31A
31B
80
39
82
83
86
38
87
1901
1901A
1901B
310A
310B
Vin
ana
Comp
fchop=fdemod
+/-1
fchop
=fdemod
Integrator
digital
Thermometer/
Binär-Codierer
DAC

Fig. 18

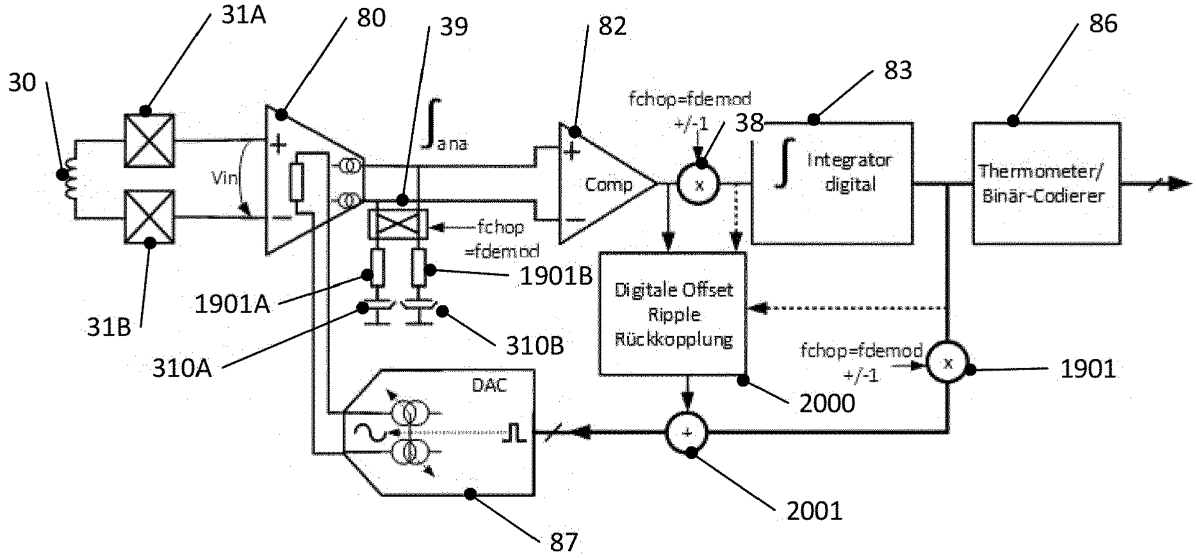

30
31A
80
39
82
86
83
fchop=fdemod
+/-1
38
Vin
∫ana
Comp
Integrator digital
Thermometer/ Binär-Codierer
fchop =fdemod
1901B
1901A
31B
310B
310A
Digitale Offset Ripple Rückkopplung
fchop=fdemod +/-1
1901
DAC
2000
2001
87


Fig. 19

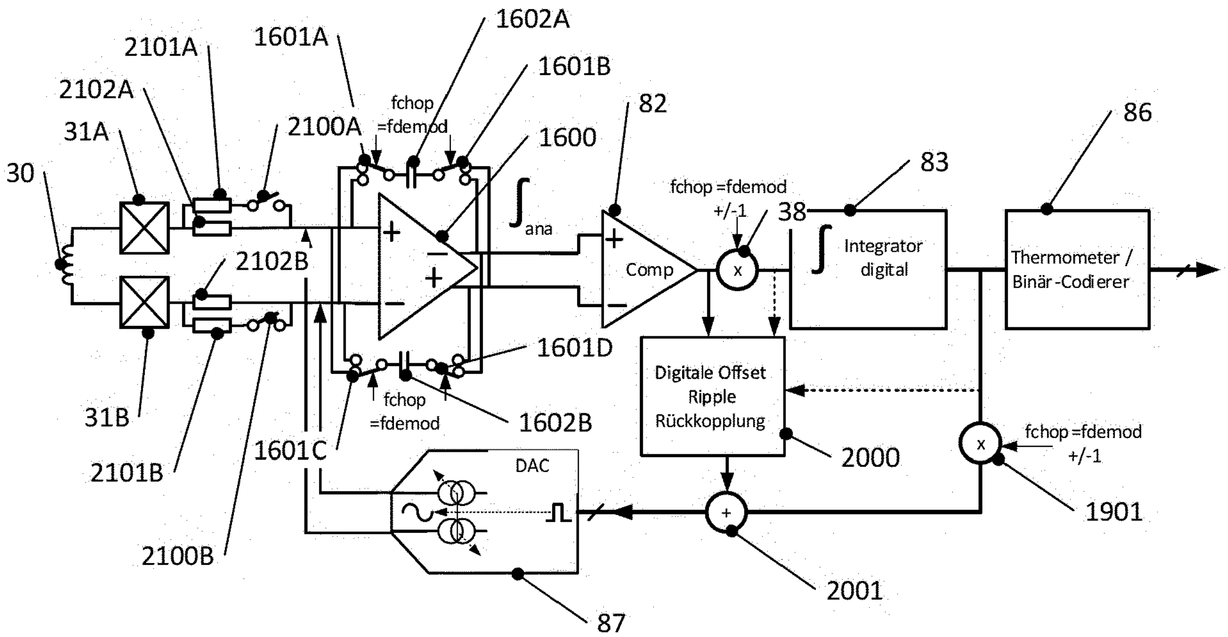

1602A
2101A
1601A
1601B
2102A
fchop =fdemod
82
31A
2100A
1600
86
30
83
∫ana
fchop =fdemod
+/-1
38
Integrator digital
Thermometer / Binär-Codierer
2102B
Comp
1601D
Digitale Offset Ripple Rückkopplung
31B
fchop =fdemod
1602B
fchop =fdemod +/-1
2000
1601C
2101B
DAC
1901
2001
2100B
87


Fig. 20

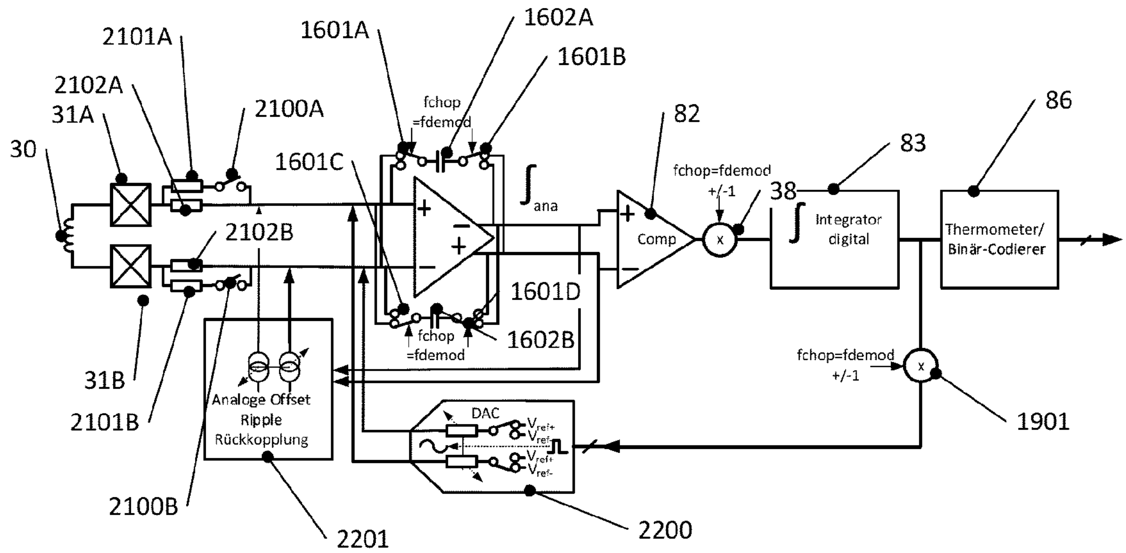

2101A
1601A
1602A
1601B
2102A
31A
2100A
fchop
=fdemod
82
86
30
1601C
fchop=fdemod
+/-1
38
83
∫ana
Comp
Integrator
digital
Thermometer/
Binär-Codierer
2102B
1601D
fchop
=fdemod
1602B
fchop=fdemod
+/-1
31B
Analoge Offset
Ripple
Rückkopplung
DAC
2101B
1901
2100B
2201
2200


Fig. 21

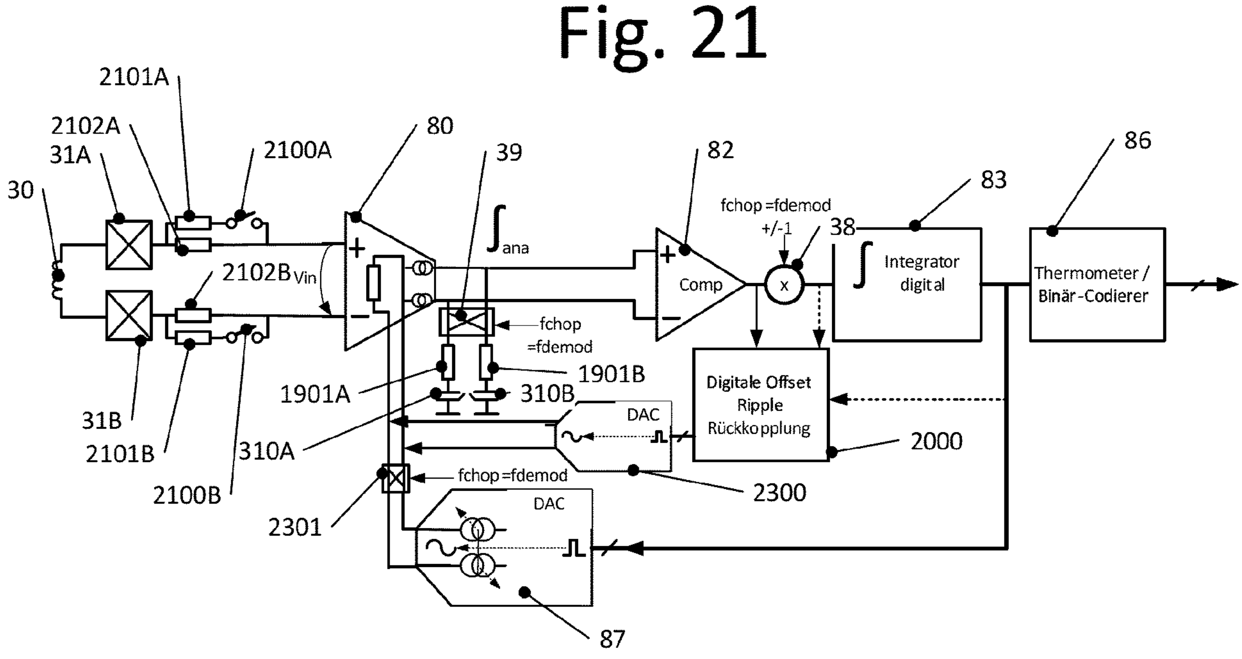

2101A
2102A
31A
2100A
80
39
82
86
30
83
fchop =fdemod
+/-1
38
∫ana
Comp
Integrator
digital
Thermometer /
Binär-Codierer
2102B
Vin
fchop
=fdemod
1901B
1901A
310B
Digitale Offset
Ripple
Rückkopplung
DAC
31B
2101B
310A
2000
2300
2100B
fchop =fdemod
2301
DAC
87


Fig. 22

Europäisches Patentamt
European Patent Office
Office européen des brevets

# EUROPÄISCHER RECHERCHENBERICHT

Nummer der Anmeldung
EP 21 21 0498

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 9 714 987 B2 (TEXAS INSTRUMENTS INC [US]) 25. Juli 2017 (2017-07-25)<br>* Spalte 8, Zeilen 26-35 *<br>* Spalte 12, Zeilen 10-17 *<br>* Spalte 13, Zeilen 48-51 *<br>* Spalte 13, Zeilen 59-61 *<br>* Spalte 14, Zeilen 3-41 *<br>* Abbildungen 1A,5 *<br>----- | 1-15 | INV.<br>H03M1/06<br>H03M3/00<br>H03M1/66 |

RECHERCHIERTE SACHGEBIETE (IPC)

H03M

Der vorliegende Recherchenbericht wurde für alle Patentansprüche erstellt

1

| Recherchenort | Abschlußdatum der Recherche | Prüfer |
|---|---|---|
| Den Haag | 31. März 2022 | Rocha, Daniel |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 21 21 0498

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-03-2022

| Im Recherchenbericht angeführtes Patentdokument | Datum der Veröffentlichung | Mitglied(er) der Patentfamilie | Datum der Veröffentlichung |
|---|---|---|---|
| US 9714987 B2 | 25-07-2017 | KEINE | |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102020111914